(19)

**Europäisches Patentamt**
**European Patent Office**
**Office européen des brevets**

(11) **EP 4 593 081 A1**

(12) **EUROPEAN PATENT APPLICATION**
published in accordance with Art. 153(4) EPC

(43) Date of publication:
**30.07.2025 Bulletin 2025/31**

(21) Application number: **23934591.1**

(22) Date of filing: **28.04.2023**

(51) International Patent Classification (IPC):
***H01L 23/498*** *(2006.01)*

(52) Cooperative Patent Classification (CPC):
**H01L 23/498**

(86) International application number:
**PCT/CN2023/091552**

(87) International publication number:
**WO 2024/221399 (31.10.2024 Gazette 2024/44)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Boe Technology Group Co., Ltd.**
**Beijing 100015 (CN)**
• **Beijing BOE Technology Development Co., Ltd.**
**Beijing 100176 (CN)**

(72) Inventors:
• **ZHANG, Shunhang**
**Beijing 100176 (CN)**
• **XUAN, Minghua**
**Beijing 100176 (CN)**
• **LIU, Dongni**
**Beijing 100176 (CN)**
• **DU, Jianhua**
**Beijing 100176 (CN)**

• **ZHOU, Ying**
**Beijing 100176 (CN)**
• **ZHANG, Zhenyu**
**Beijing 100176 (CN)**
• **ZHANG, Zhen**
**Beijing 100176 (CN)**
• **LI, Peirou**
**Beijing 100176 (CN)**
• **IM, Yunsik**
**Beijing 100176 (CN)**
• **YU, Lianfu**
**Beijing 100176 (CN)**
• **ZHENG, Haoliang**
**Beijing 100176 (CN)**
• **XIAO, Li**
**Beijing 100176 (CN)**
• **GUAN, Feng**
**Beijing 100176 (CN)**

(74) Representative: **Potter Clarkson**
**Chapel Quarter**
**Mount Street**
**Nottingham NG1 6HQ (GB)**

(54) **DISPLAY PANEL AND MANUFACTURING METHOD THEREFOR, AND DISPLAY DEVICE**

(57)     Provided is a display panel, including: a base substrate including at least one side region and a display region; pixel units in the display region; a terminal located in the side region on the base substrate; a first wire on the base substrate, having one end electrically connected to the terminal and the other end electrically connected to a pixel driving circuit; a second wire on the base substrate, having one end electrically connected to the terminal, the second wire extends in a direction from the terminal to a side edge of the base substrate. The display panel includes a first conductive layer, a first planarization layer, a second conductive layer and a second planarization layer sequentially provided on the base substrate. An orthographic projection of the terminal on the base substrate is spaced apart from orthographic projections of the first and second planarization layers on the base substrate.

FIG. 5

EP 4 593 081 A1

**Description**

TECHNICAL FIELD

The present disclosure relates to the field of display technology, and in particular to a display panel, a display device, and a method of manufacturing a display panel.

BACKGROUND

Light emitting diode (LED) technology has been developed for nearly thirty years, and its application range is expanding continuously. For example, a light emitting diode may be applied in a field of display and serves as a backlight source of a display device or as an LED display screen. At present, LED display has sprung up in outdoor display and central control screen display, and has become a popular display carrier in the industry. With the development of technology and in order to meet needs of users, splicing small screens to achieve large-screen display is a direction of current LED display development. In a spliced display product, how to design a structure of a display panel so that the display panel meets requirements of the spliced display product while having a required reliability is one of topics of concern to R&D personnel of display products.

The above information disclosed in this section is just for understanding of the background of technical concepts of the present disclosure. Therefore, the above information may include information that does not constitute the related art.

SUMMARY

In an aspect, a display substrate is provided, including: a base substrate including at least one side region and a display region, the at least one side region is closer to a side edge of the base substrate than the display region; a plurality of pixel units provided in the display region and distributed in an array on the base substrate, at least one pixel unit includes a light emitting diode and a pixel driving circuit for driving the light emitting diode; a terminal provided on the base substrate and located in the side region; a first wire provided on the base substrate, the first wire has one end electrically connected to the terminal and the other end electrically connected to the pixel driving circuit; and a second wire provided on the base substrate, the second wire has one end electrically connected to the terminal, and the second wire extends in a direction from the terminal to the side edge of the base substrate. The display panel includes: a first conductive layer provided on the base substrate; a first planarization layer provided on a side of the first conductive layer away from the base substrate; a second conductive layer provided on a side of the first planarization layer away from the base substrate; and a second planarization layer provided on a side of the second conductive layer away from the base substrate, and an orthographic projection of the terminal on the base substrate is spaced apart from an orthographic projection of the first planarization layer on the base substrate, and the orthographic projection of the terminal on the base substrate is spaced apart from an orthographic projection of the second planarization layer on the base substrate.

According to some exemplary embodiments, in a region between the terminal and the light emitting diode closest to the terminal, the orthographic projection of the second planarization layer on the base substrate falls within the orthographic projection of the first planarization layer on the base substrate.

According to some exemplary embodiments, the display panel further includes a first passivation layer provided between the first planarization layer and the second conductive layer; and in a region between the terminal and the light emitting diode closest to the terminal, the orthographic projection of the first planarization layer on the base substrate falls within an orthographic projection of the first passivation layer on the base substrate.

According to some exemplary embodiments, the display panel further includes a second passivation layer provided on a side of the second planarization layer away from the base substrate; and in the region between the terminal and the light emitting diode closest to the terminal, the orthographic projection of the second planarization layer on the base substrate falls within an orthographic projection of the second passivation layer on the base substrate.

According to some exemplary embodiments, the display panel includes a first via hole located in the first passivation layer and a second via hole located in the second passivation layer; and an orthographic projection of the second via hole on the base substrate falls within an orthographic projection of the first via hole on the base substrate, and at least one of the orthographic projection of the first via hole on the base substrate and the orthographic projection of the second via hole on the base substrate falls within the orthographic projection of the terminal on the base substrate.

According to some exemplary embodiments, the terminal includes a first terminal portion located in the first conductive layer and a second terminal portion located in the second conductive layer.

According to some exemplary embodiments, the display panel includes a plurality of conductive pads located in the second conductive layer, and the light emitting diode includes a first electrode in contact with a conductive pad and a second electrode in contact with another conductive pad; and the plurality of conductive pads include a first conductive pad closest to the side edge of the base substrate, a first side edge of the orthographic projection of the second planarization layer on the base substrate is closer to the terminal than a first side edge of an orthographic projection of the first conductive pad on the base substrate, the first side edge of the orthographic projection of the first conductive pad on the base substrate is a side edge facing the terminal among side edges of the orthographic projection of the first conductive pad on the base substrate, and the first side edge of the orthographic projection of the second planarization layer on the base substrate is a side edge facing the terminal among side edges of the orthographic projection of the second planarization layer on the base substrate.

According to some exemplary embodiments, the first side edge of the orthographic projection of the second planarization layer on the base substrate includes a first side edge portion, and the first side edge portion of the second planarization layer is a portion of the first side edge of the second planarization layer directly opposite to the terminal; and the first side edge of the orthographic projection of the first conductive pad on the base substrate is spaced apart from the first side edge portion of the first side edge of the orthographic projection of the second planarization layer on the base substrate by a first specified distance in a first direction perpendicular to the side edge of the base substrate.

According to some exemplary embodiments, a first side edge of the orthographic projection of the first planarization layer on the base substrate includes a first side edge portion, the first side edge of the orthographic projection of the first planarization layer on the base substrate is a side edge facing the terminal among side edges of the orthographic projection of the first planarization layer on the base substrate, and the first side edge portion of the first planarization layer is a portion of the first side edge of the first planarization layer directly opposite to the terminal; and the first side edge portion of the first side edge of the orthographic projection of the first planarization layer on the base substrate is closer to the terminal than the first side edge portion of the first side edge of the orthographic projection of the second planarization layer on the base substrate.

According to some exemplary embodiments, the first side edge portion of the first side edge of the orthographic projection of the first planarization layer on the base substrate is spaced apart from the first side edge portion of the first side edge of the orthographic projection of the second planarization layer on the base substrate by a second specified distance in the first direction.

According to some exemplary embodiments, the first side edge portion of the first side edge of the orthographic projection of the first planarization layer on the base substrate is spaced apart from a first side edge of the orthographic projection of the terminal on the base substrate by a third specified distance in the first direction, and the first side edge of the orthographic projection of the terminal on the base substrate is farthest away from the side edge of the base substrate in the first direction among side edges of the orthographic projection of the terminal on the base substrate.

According to some exemplary embodiments, the third specified distance is greater than the first specified distance; and/or the first specified distance is greater than the second specified distance.

According to some exemplary embodiments, the display panel includes a plurality of terminals, and a gap is formed between the plurality of terminals; the display panel includes a first dam, and the first dam is directly opposite to the gap in the first direction perpendicular to the side edge of the base substrate; and an orthographic projection of at least part of the first dam on the base substrate protrudes toward the gap in the first direction relative to the first side edge portion of the first side edge of the orthographic projection of the first planarization layer on the base substrate.

According to some exemplary embodiments, the first dam includes a first dam portion located in the first planarization layer and a second dam portion located in the second planarization layer; and the first dam portion is a portion extending continuously with a portion of the first planarization layer located in the display region, and the second dam portion is a portion extending continuously with a portion of the second planarization layer located in the display region.

According to some exemplary embodiments, an orthographic projection of the second dam portion on the base substrate falls within an orthographic projection of the first dam portion on the base substrate.

According to some exemplary embodiments, the display panel includes a plurality of terminals, and a gap is formed between the plurality of terminals; the display panel includes a second dam, and the second dam is directly opposite to the gap in a first direction perpendicular to the side edge of the base substrate; the second dam is spaced apart from a portion of the first planarization layer located in the display region, and the second dam is closer to the gap than the portion of the first planarization layer located in the display region; and the second dam is spaced apart from a portion of the second planarization layer located in the display region, and the second dam is closer to the gap than the portion of the second planarization layer located in the display region.

According to some exemplary embodiments, the second dam includes a first sub-dam located in the first planarization layer and a second sub-dam located in the second planarization layer; and an orthographic projection of the second sub-dam on the base substrate falls within an orthographic projection of the first sub-dam on the base substrate.

According to some exemplary embodiments, the second dam further includes a third sub-dam located in the first passivation layer and a fourth sub-dam located in the second passivation layer; the first sub-dam is spaced apart from the portion of the first planarization layer located in the display region; the second sub-dam is spaced apart from the portion of the second planarization layer located in the display region; the third sub-dam is a portion extending continuously with a portion of the first passivation layer located in the display region; and the fourth sub-dam is a portion extending continuously with a portion of the second passivation layer located in the display region.

According to some exemplary embodiments, an orthographic projection of the second terminal portion on the base substrate falls within an orthographic projection of the first terminal portion on the base substrate.

According to some exemplary embodiments, the orthographic projection of the second via hole on the base substrate falls within an orthographic projection of a second terminal portion on the base substrate, and a portion of the second passivation layer covers a side edge of the second terminal portion; and/or the orthographic projection of the first via hole on the base substrate falls within an orthographic projection of a first terminal portion on the base substrate, and a portion of the first passivation layer covers a side edge of the first terminal portion.

According to some exemplary embodiments, a vertical distance between a first side edge of the orthographic projection of the second terminal portion on the base substrate and a first side edge of the orthographic projection of the first terminal portion on the base substrate is greater than 2 microns, and the first side edge of the orthographic projection of the second terminal portion on the base substrate and the first side edge of the orthographic projection of the first terminal portion on the base substrate are side edges on a same side of the orthographic projections of the first and second terminal portions on the base substrate.

According to some exemplary embodiments, in a second direction perpendicular to the first direction, a ratio of a size of the first dam to a size of the gap directly opposite to the first dam is in a range from 0.6 to 1.5.

According to some exemplary embodiments, an orthographic projection of the first dam in the first direction does not overlap with an orthographic projection of the terminal in the first direction.

According to some exemplary embodiments, in a second direction perpendicular to the first direction, a ratio of a size of the second dam to a size of the gap directly opposite to the second dam is in a range from 0.6 to 1.

According to some exemplary embodiments, an orthographic projection of the second dam in the first direction overlaps partially with an orthographic projection of the terminal in the first direction.

In another aspect, a display device is provided, including the display panel as described above.

According to some exemplary embodiments, the display device includes a plurality of display panels spliced together.

In yet another aspect, a method of manufacturing a display panel is provided, including: providing a base substrate, the base substrate includes a display region, a side region closer to a side edge of the base substrate than the display region, and a region to be cut closer to the side edge of the base substrate than the side region; forming a first conductive material layer on the base substrate; performing a patterning process on the first conductive material layer to form a first terminal portion located in the side region and a first wire extending from at least one side region to the display region; forming a first planarization layer on a side of the first terminal portion and the first wire away from the base substrate; forming a second conductive material layer on a side of the first planarization layer away from the base substrate; performing a patterning process on the second conductive material layer to form a second terminal portion located in the side region; and forming a second planarization layer on a side of the second terminal portion away from the base substrate, each of an orthographic projection of the first terminal portion on the base substrate and an orthographic projection of the second terminal portion on the base substrate is spaced apart from an orthographic projection of the first planarization layer on the base substrate, and each of the orthographic projection of the first terminal portion on the base substrate and the orthographic projection of the second terminal portion on the base substrate is spaced apart from an orthographic projection of the second planarization layer on the base substrate.

According to some exemplary embodiments, in the step of performing a patterning process on the first conductive material layer, a first test terminal portion is further formed in the region to be cut; in the step of performing a patterning process on the second conductive material layer, a second test terminal portion is further formed in the region to be cut, and an orthographic projection of the second test terminal portion on the base substrate covers an orthographic projection of the first test terminal portion on the base substrate.

According to some exemplary embodiments, the method further includes: performing an electroless nickel immersion gold process on the second terminal portion to form a protective layer on a surface of the second terminal portion away from the base substrate, in a case that the first test terminal portion and the second test terminal portion are located on the base substrate

BRIEF DESCRIPTION OF THE DRAWINGS

With following descriptions of the present disclosure with reference to the accompanying drawings, other objectives and advantages of the present disclosure may be obvious and the present disclosure may be understood comprehensively.

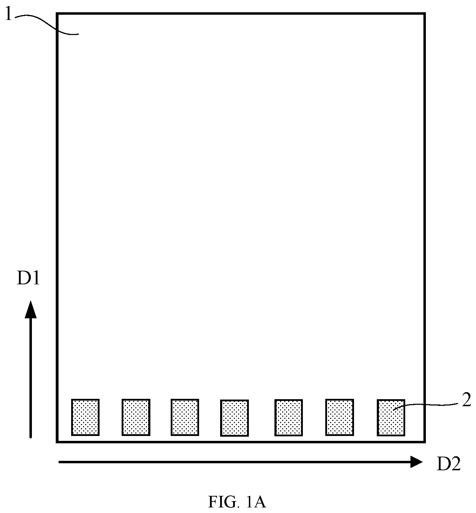

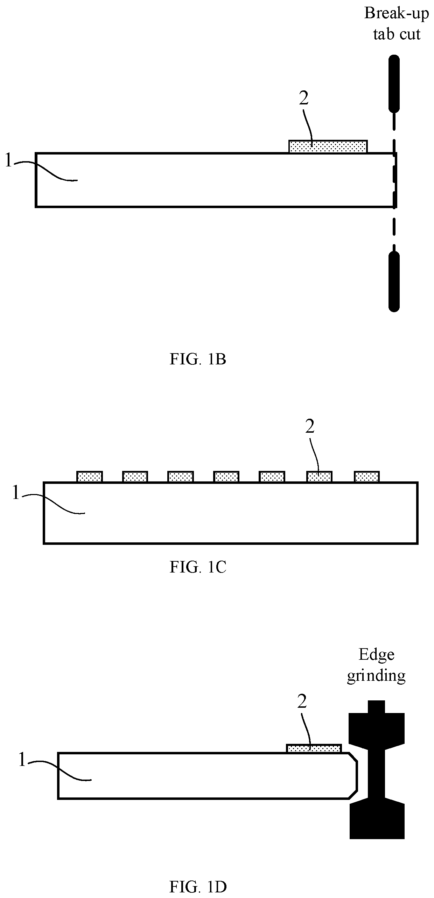

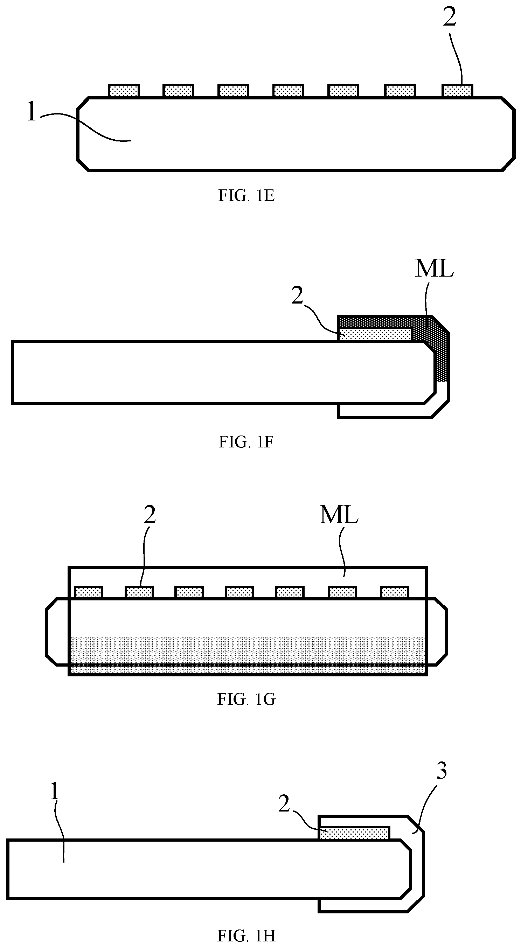

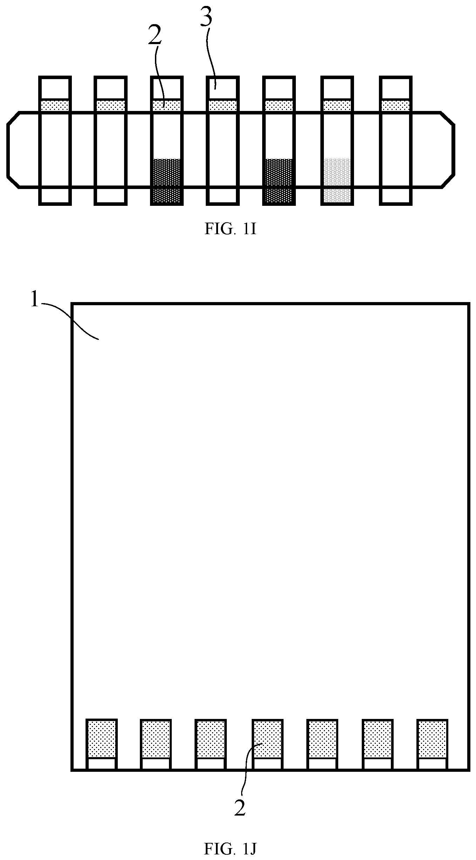

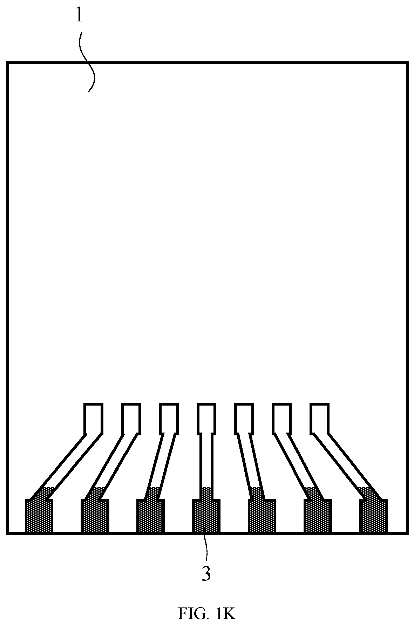

FIG. 1A to FIG. 1K schematically show flow diagrams of a method of processing a display panel to achieve narrow-seam or seamless splicing, in which FIG. 1A and FIG. 1J show top views of the display panel, in which a front surface of the display panel is schematically shown respectively, FIG. 1K shows a bottom view of the display panel, in which a back surface of the display panel is schematically shown, FIG. 1B, FIG. 1D, FIG. 1F and FIG. 1H show side views of the display panel observed in a second direction in FIG. 1A, and FIG. 1C, FIG. 1E, FIG. 1G and FIG. 1I show side views of the display panel observed in a first direction in FIG. 1A;

FIG. 2 schematically shows a distance design requirement for a terminal in a splicing edge space;

FIG. 3 shows a schematic plan view of a display panel according to the embodiments of the present disclosure;

FIG. 4 shows a partial plan view of a display panel according to some exemplary embodiments of the present disclosure;

FIG. 5 shows a cross-sectional view of the display panel according to some exemplary embodiments of the present disclosure taken along line AA' in FIG. 4;

FIG. 6 and FIG. 7 respectively show schematic plan views of a display panel during processing according to some exemplary embodiments of the present disclosure, in which FIG. 6 schematically shows a partial plan view of a display panel after a sputtering process and before a laser etching process, and FIG. 7 schematically shows a partial plan view of a display panel after the laser etching process;

FIG. 8 shows a partial plan view of a display panel according to some exemplary embodiments of the present disclosure, in which a dam design is schematically shown;

FIG. 9 shows a partial plan view of a display panel after a laser etching process according to some exemplary embodiments of the present disclosure;

FIG. 10A to FIG. 10F respectively show schematic diagrams of an intermediate structure of the display panel with the dam design shown in FIG. 8, in which FIG. 10A to FIG. 10F schematically show structures of the display panel located in a terminal region and a display region adjacent to the terminal region;

FIG. 11 shows an SEM image of a display panel with a dam design after a laser etching process;

FIG. 12 shows a cross-sectional view of a display panel according to some exemplary embodiments of the present disclosure, and FIG. 13 shows a partial plan view of a display panel according to some exemplary embodiments of the present disclosure, in which FIG. 12 and FIG. 13 schematically show another dam design;

FIG. 14 shows a cross-sectional view of a display panel at a terminal according to some exemplary embodiments of the present disclosure;

FIG. 15 shows a plan view of a display panel at a terminal according to some exemplary embodiments of the present disclosure;

FIG. 16 shows a photo of a structure of a display panel at a terminal after an electroless nickel immersion gold process according to some exemplary embodiments of the present disclosure;

FIG. 17 shows an SEM image of a display panel at a terminal according to some exemplary embodiments of the present disclosure;

FIG. 18 shows a cross-sectional view of a display panel at a terminal according to other exemplary embodiments of the present disclosure;

FIG. 19 shows a plan view of a display panel at a terminal according to other exemplary embodiments of the present disclosure;

FIG. 20 shows an SEM image of a display panel at a terminal according to other exemplary embodiments of the present disclosure;

FIG. 21 schematically shows a process of a test terminal reacting with a terminal during an electroless nickel immersion gold process on the display panel;

FIG. 22 shows an SEM image of a terminal formed after the process shown in FIG. 21 is executed;

FIG. 23 shows a cross-sectional view of a display panel at a test terminal before executing an electroless nickel immersion gold process on the display panel;

FIG. 24 shows a cross-sectional view of a display panel at a test terminal before executing an electroless nickel immersion gold process on the display panel;

FIG. 25 shows a plan view of the display panel shown in FIG. 24;

FIG. 26 shows an SEM image of a terminal of a display panel having the structure shown in FIG. 24;

FIG. 27 shows a flowchart of a method of manufacturing a display panel according to exemplary embodiments of the present disclosure; and

FIG. 28 shows a schematic diagram of a display device according to the exemplary embodiments of the present disclosure.

It should be noted that for the sake of clarity, in the accompanying drawings used to describe the embodiments of the present disclosure, sizes of layers, structures or regions may be enlarged or reduced, that is, these accompanying drawings are not drawn according to actual scale.

DETAILED DESCRIPTION OF EMBODIMENTS

In the following descriptions, for the purpose of explanation, many specific details are set forth to provide a comprehensive understanding of various exemplary embodiments. However, it is obvious that various exemplary embodiments may be implemented without these specific details or with one or more equivalent arrangements. In other cases, well-known structures and devices are shown in block diagrams in order to avoid unnecessarily obscuring the various exemplary embodiments. In addition, the various exemplary embodiments may be different, but need not to be exclusive. For example, without departing from the inventive concept, specific shapes, configurations and characteristics in an exemplary embodiment may be used or implemented in another exemplary embodiment.

In the accompanying drawings, for clarity and/or description purposes, sizes and relative sizes of elements may be enlarged. Accordingly, the size and relative size of each element need not to be limited to those shown in the accompanying drawings. When the exemplary embodiments may be implemented differently, the specific process sequence may be executed differently from the sequence described. For example, two consecutively described processes may be executed substantially simultaneously or in a reverse order. In addition, the same reference numerals represent the same elements.

When an element is described as being "on", "connected to" or "coupled to" another element, the element may be directly on the another element, directly connected to the another element, or directly coupled to the another element, or an intermediate element may be provided. However, when an element is described as being "directly on", "directly connected to" or "directly coupled to" another element, no intermediate element is provided. Other terms and/or expressions used to describe the relationship between elements, for example, "between" and "directly between", "adjacent" and "directly adjacent", "on" and "directly on", and so on, should be interpreted in a similar manner. In addition, the term "connection" may refer to a physical connection, an electrical connection, a communication connection, and/or a fluid connection. In addition, X-axis, Y-axis and Z-axis are not limited to three axes of a rectangular coordinate system, and may be interpreted in a broader meaning. For example, the X-axis, the Y-axis and the Z-axis may be perpendicular to each other, or may represent different directions that are not perpendicular to each other. For objectives of the present disclosure, "at least one selected from X, Y or Z" and "at least one selected from a group consisting of X, Y and Z" may be interpreted as only X, only Y, only Z, or any combination of two or more of X, Y and Z, such as XYZ, XY, YZ and XZ. As used herein, the term "and/or" includes any and all combinations of one or more of the listed related items.

It should be understood that, although terms "first", "second" and so on may be used here to describe different elements, those elements should not be limited by those terms. Those terms are just used to distinguish one element from another element. For example, without departing from the scope of the exemplary embodiments, a first element may be named as a second element, and similarly, a second element may be named as a first element.

Herein, an inorganic light emitting diode refers to a light emitting element made from an inorganic material, and LED represents an inorganic light emitting element different from OLED. Specifically, the inorganic light emitting element may include a mini light emitting diode (Mini LED) and a micro light emitting diode (Micro LED). The Micro LED refers to an ultra-small light emitting diode with a grain size below 100 microns. The Mini LED refers to a small light emitting diode with a grain size between the Micro LED and the traditional LED. For example, a grain size of Mini LED may range from 50 microns to 400 microns.

With the development of technology, LED display devices have developed rapidly, which have been gradually applied to, for example, outdoor displays and central control large screen displays. The inventors found through research that, on one hand, a large-sized display screen is required in application scenarios such as outdoor displays and central control large screen displays; on the other hand, LED display devices applied to outdoor displays and central control large screen displays are mainly used for users to watch from a long distance. Based on this, it is possible to splice a plurality of small screens to achieve large screen display. In a process of splicing a plurality of small screens into a large screen, it is needed to process a display panel to achieve narrow-seam or seamless splicing.

FIG. 1A to FIG. 1K schematically show flow diagrams of a method of processing a display panel to achieve narrow-seam or seamless splicing, in which FIG. 1A and FIG. 1J show top views of the display panel, in which a front surface of the display panel is schematically shown respectively, FIG. 1K shows a bottom view of the display panel, in which a back surface of the display panel is schematically shown, FIG. 1B, FIG. 1D, FIG. 1F and FIG. 1H show side views of the display panel observed in a second direction in FIG. 1A, and FIG. 1C, FIG. 1E, FIG. 1G and FIG. 1I show side views of the display panel observed in a first direction in FIG. 1A.

Referring to FIG. 1A to FIG. 1K, a terminal 2 is formed on a base substrate 1 of a display panel, and the terminal 2 is electrically connected to a chip or circuit board through a signal wire 3. In a narrow-seam or seamless splicing solution, the chip or circuit board needs to be arranged on a back surface of the base substrate 1, and the terminal 2 on a front surface of the base substrate 1 is electrically connected to the chip or circuit board on the back surface of the base substrate 1 through the signal wire 3. In order to achieve such connection, it is needed to use side and back processes. FIG. 1A schematically shows a splicing edge of a motherboard. In this embodiment, the terminal 2 for connecting with the signal wire is located on a signal input side of the motherboard. As shown in FIG. 1B and FIG. 1C, it is needed to cut a break-up tab of the motherboard, that is, to reduce a size of the splicing edge of the motherboard. For example, a laser cutting process may be used for cutting. As shown in FIG. 1D and FIG. 1E, it is needed to perform edge grinding on the cut motherboard so as to further reduce the size of the splicing edge of the motherboard. After cutting and edge grinding, a display panel is formed. Then, a filming protection is applied to a display region of the display panel so as to avoid damaging a structure in the display region in subsequent processes. As shown in FIG. 1F and FIG. 1G, a metal layer ML may be formed using a sputtering process, a portion of the metal layer ML is connected to the terminal 2, a portion of the metal layer ML is formed on a side surface of the display panel, and another portion of the metal layer ML is formed on a back surface of the display panel, for example, in a fan-out region on the back surface. For example, the metal layer ML may include metals such as Ti/Cu/Ti. As shown in FIG. 1H and FIG. 1I, the metal layer ML is etched using an etching process so as to form a plurality of signal wires 3. For example, the etching process may be a laser etching process. In this way, the terminal 2 located on the front surface is connected to the fan-out region on the back surface through the signal wire 3 and then connected to the chip or circuit board.

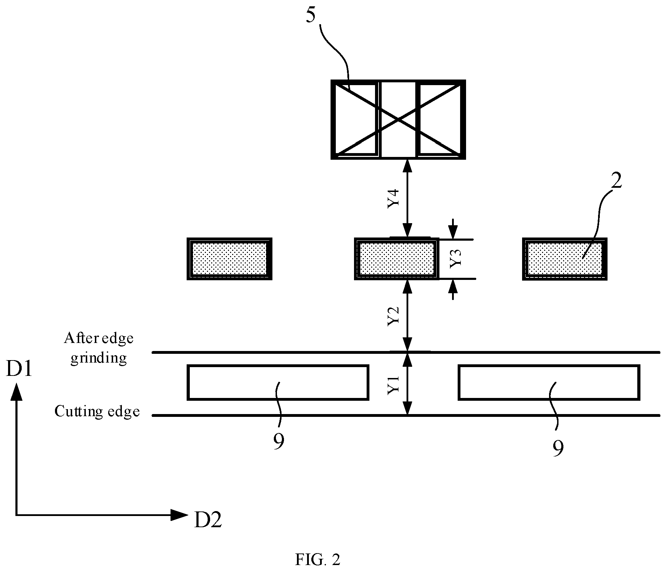

In the narrow-seam or seamless splicing solution, the signal wire 3 formed on the side surface of the display panel is used to transmit data signals, power signals, scanning signals and other signals of the display panel to the back surface of the display panel, and is bound to the chip or circuit board on the back surface. In the narrow-seam or seamless splicing solution, a position design of the terminal 2 on the front surface of the display panel is important. On one hand, the terminal 2 should not be too close to an edge of the display panel, because the terminal 2 that is too close to the edge of the display panel has a high risk of being damaged in the cutting and edge grinding processes; on the other hand, the terminal 2 should not be too far away from the edge of the display panel, because the terminal 2 that is too far away from the edge of the display panel may cause a large width of a subsequent splicing seam, which is not conducive to narrow-seam or seamless splicing. FIG. 2 schematically shows a distance design requirement for the terminal in a splicing edge space. As shown in FIG. 2, a splicing edge space design is divided into four parts in the first direction D1, including: a part that is grinded off from a cutting edge has a size Y1 in the first direction D1, which is used for protecting side wires and serving as a splicing seam margin; an edge formed after edge grinding is spaced from the terminal 2 by a size Y2 in the first direction D1, which is designed to ensure that the edge grinding does not damage the terminal 2; the terminal 2 has a size Y3 in the first direction D1, which is used to ensure a contact area of the terminal 2 with the signal wire 3; the terminal 2 is spaced from a light emitting device 5 (for example, LED) by a size Y4 in the first direction, which is used to ensure that the above-mentioned sputtering process and etching process do not damage the light emitting device 5.

In the exemplary embodiments of FIG. 1A and FIG. 2, a first direction D1 and a second direction D2 are schematically shown. For example, a plurality of pixel units may be arranged in an array in the first direction D1 and the second direction D2. It should be noted that the embodiments of the present disclosures are not limited to this.

The inventors found through research that in the narrow-seam or seamless splicing solution, the laser cutting and sputtering processes in the side process may damage a planarization layer (for example, including a resin material) located in a side region, and may generate a cascading effect so as to damage a planarization layer in the display region. Therefore, in the embodiments of the present disclosure, the planarization layer at the terminal located in the side region of the display panel is removed.

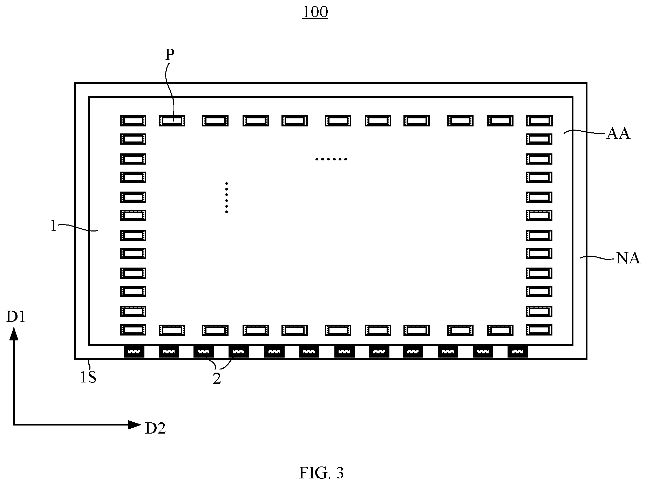

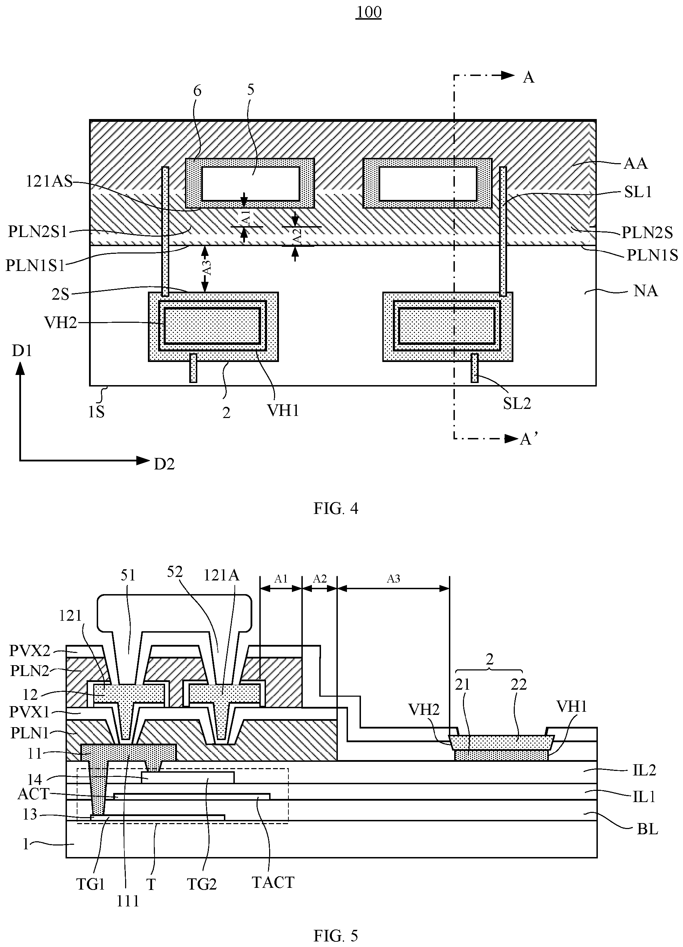

FIG. 3 shows a schematic plan view of a display panel according to the embodiments of the present disclosure. FIG. 4 shows a partial plan view of a display panel according to some exemplary embodiments of the present disclosure. FIG. 5 shows a cross-sectional view of the display panel according to some exemplary embodiments of the present disclosure taken along line AA' in FIG. 4. For example, FIG. 4 and FIG. 5 schematically show a portion of the display panel located in the side region where the terminal is located.

Referring to FIG. 3, FIG. 4 and FIG. 5 in combination, the display panel 100 may include a base substrate 1, which includes at least one side region NA and a display region AA. The at least one side region NA is closer to a side edge 1S of the base substrate 1 than the display region AA. For example, the at least one side region NA may include a region where the terminal 2 is located, or a region where a splicing edge is located.

It should be noted that herein, unless otherwise specified, the term "side edge" refers to a side surface of the base substrate, a component, or an element. In the plan view of, for example, FIG. 3 or FIG. 4, the "side edge" is shown as a line. For example, a first side edge 1S is a lowermost line.

The display panel 100 may further include a plurality of pixel units P arranged in the display region AA. The plurality of pixel units P are distributed in an array on the base substrate 1, and at least one pixel unit P includes a light emitting diode 5 and a pixel driving circuit 6 for driving the light emitting diode 5. For example, the light emitting diode 5 may include a mini light emitting diode or a micro light emitting diode, which may adopt a chip structure of a light emitting diode. The pixel driving circuit 6 may include at least one transistor T, which may include a source electrode, a gate electrode, a drain electrode, and an active layer TACT. For example, the transistor T may have a dual gate structure, which may include a first gate electrode TG1 located below the active layer TACT and a second gate electrode TG2 located above the active layer TACT.

For example, referring to FIG. 5, the display panel 100 may include a plurality of film layers provided on the base substrate 1. For example, the plurality of film layers include: a third conductive layer 13 provided on the base substrate 1, a buffer layer BL provided on a side of the third conductive layer 13 away from the base substrate, a semiconductor layer ACT provided on a side of the buffer layer BL away from the base substrate, a first insulation layer IL1 provided on a side of the semiconductor layer ACT away from the base substrate, a fourth conductive layer 14 provided on a side of the first insulation layer IL1 away from the base substrate, a second insulation layer IL2 provided on a side of the fourth conductive layer 14 away from the base substrate, a first conductive layer 11 provided on a side of the second insulation layer IL2 away from the base substrate, a first planarization layer PLN1 provided on a side of the first conductive layer 11 away from the base substrate, a first passivation layer PVX1 provided on a side of the first planarization layer PLN1 away from the base substrate, a second conductive layer 12 provided on a side of the first passivation layer PVX1 away from the base substrate, a second planarization layer PLN2 provided on a side of the second conductive layer 12 away from the base substrate, and a second passivation layer PVX2 provided on a side of the second planarization layer PLN2 away from the base substrate.

For example, a material of the base substrate 1 may include but not be limited to glass, quartz, plastic, silicon, polyimide, etc.

Continuing to refer to FIG. 5, the first gate electrode TG1 may be located in the third conductive layer 13, and the second gate electrode TG2 may be located in the fourth conductive layer 14, that is, the third conductive layer 13 and the fourth conductive layer 14 may be conductive layers including gate materials. The active layer TACT may be located in the semiconductor layer ACT. The display panel 100 may include a conductive connecting portion 111, which may be located, for example, in the first conductive layer 11. The conductive connecting portion 111 is used to electrically connect the first gate electrode TG1 and the second gate electrode TG2.

The display panel 100 may include a plurality of conductive pads 121 located in the second conductive layer 12. The light emitting diode 5 includes a first electrode 51 and a second electrode 52. The first electrode 51 of the light emitting diode is in contact with a conductive pad 121, and the second electrode 52 of the light emitting diode is in contact with another conductive pad 121. The conductive pad 121 in contact with the first electrode 51 is further in contact with the conductive connecting portion 111.

In the embodiments of the present disclosure, the source electrode and the drain electrode of the transistor T, the conductive connecting portion 111, and other components may be located in the first conductive layer 11, that is, the first conductive layer 11 may be a conductive layer including a source or drain material. The conductive pad used for electrical connection with the electrode of the light emitting diode may be located in the second conductive layer 12. For example, the second conductive layer 12 may include a material with a high conductivity such as Cu.

Referring to FIG. 4 and FIG. 5, the display panel 100 may further include a terminal 2 provided on the base substrate 1 and located in the side region NA. As mentioned above, the terminal 2 located on the front surface of the display panel 100 is connected to the fan-out region on the back surface through the signal wire 3 and is further connected to the chip or circuit board. Specifically, the display panel 100 may include: a first wire SL1 provided on the base substrate 1, where the first wire SL1 has one end electrically connected to the terminal 2 and the other end electrically connected to the pixel driving circuit 6; and a second wire SL2 provided on the base substrate 1, where the second wire SL2 has one end electrically connected to the terminal 2, and the second wire SL2 extends in a direction from the terminal 2 to the side edge 1S of the base substrate 1. In this way, data signals, power signals, scanning signals, and other signals generated by the chip or circuit board may be input to the pixel driving circuit 6, and the pixel driving circuit 6 may control the light emitting diode to emit light under a control of various signals.

Referring to FIG. 4 and FIG. 5, an orthographic projection of the terminal 2 on the base substrate 1 is spaced apart from an orthographic projection of the first planarization layer PLN1 on the base substrate 1 and spaced apart from an orthographic projection of the second planarization layer PLN2 on the base substrate 1. For example, in the embodiments of the present disclosure, a plurality of terminals 2 may be provided. The orthographic projection of each terminal 2 on the base substrate 1 is spaced apart from the orthographic projection of the first planarization layer PLN1 on the base substrate 1 and spaced apart from the orthographic projection of the second planarization layer PLN2 on the base substrate 1.

Herein, unless otherwise specified, the expression "spaced apart" means not overlapping. That is to say, in such embodiments, the orthographic projection of the terminal 2 on the base substrate 1 does not overlap with the orthographic projection of the first planarization layer PLN1 on the base substrate 1, and does not overlap with the orthographic projection of the second planarization layer PLN2 on the base substrate 1.

In the embodiments of the present disclosure, no planarization layer is provided in the region where the terminal 2 is located, that is, the planarization layer at the terminal located in the side region of the display panel is removed. In this way, the laser cutting and sputtering processes in the side process may be executed without damaging the planarization layer in the display region AA, which may help improve a reliability of the display panel.

Continuing to refer to FIG. 4 and FIG. 5, in a region between the terminal 2 and the light emitting diode 5 closest to the terminal 2, the orthographic projection of the second planarization layer PLN2 on the base substrate 1 falls within the orthographic projection of the first planarization layer PLN1 on the base substrate 1. That is to say, in a region between the plurality of terminals 2 and a row of light emitting diodes 5 closest to the terminals 2, the orthographic projection of the second planarization layer PLN2 on the base substrate 1 falls within the orthographic projection of the first planarization layer PLN1 on the base substrate 1. That is to say, an edge of the second planarization layer PLN2 is further inward than an edge of the first planarization layer PLN1, so that the second planarization layer PLN2 is located completely above the first planarization layer PLN1. When forming the first planarization layer PLN1, a segment difference may be formed at the edge of the first planarization layer PLN1 due to a design of removing the first planarization layer PLN1 from the region where the terminal 2 is located. In such embodiments, the second planarization layer PLN2 is located completely above the first planarization layer PLN1, and it is avoided that the second planarization layer PLN2 is formed at the segment difference at the edge of the first planarization layer PLN1, which may help improve a reliability of the second planarization layer PLN2.

In the embodiments of the present disclosure, both the first passivation layer PVX1 and the second passivation layer PVX2 extend from the display region AA to the side region NA, that is, the first passivation layer PVX1 and the second passivation layer PVX2 are still provided in the side region NA. Referring to FIG. 4 and FIG. 5, in the region between the terminal 2 and the light emitting diode 5 closest to the terminal 2, i.e., in the region between the plurality of terminals 2 and the row of light emitting diodes 5 closest to the terminals 2, the orthographic projection of the first planarization layer PLN1 on the base substrate 1 falls within an orthographic projection of the first passivation layer PVX1 on the base substrate 1; the orthographic projection of the first planarization layer PLN1 on the base substrate 1 falls within an orthographic projection of the second passivation layer PVX2 on the base substrate 1; the orthographic projection of the second planarization layer PLN2 on the base substrate 1 falls within the orthographic projection of the first passivation layer PVX1 on the base substrate 1; and the orthographic projection of the second planarization layer PLN2 on the base substrate 1 falls within the orthographic projection of the second passivation layer PVX2 on the base substrate 1. Through such design, the first passivation layer PVX1 and the second passivation layer PVX2 may protect the first planarization layer PLN1 and the second planarization layer PLN2. Specifically, an edge of the first planarization layer PLN1 is covered by the first passivation layer PVX1 and covered by the second passivation layer PVX2. Due to the protection of the two passivation layers, sputtered Ti/Cu/Ti metal may not permeate into the planarization layer during the sputtering process, which may help protect a reliability of the pixel driving circuit and the light emitting diode in the display region of the display panel.

The display panel 100 may include a first via hole VH1 located in the first passivation layer PVX1 and a second via hole VH2 located in the second passivation layer PVX2. The terminal 2 is formed in the first via hole VH1 and the second via hole VH2. Referring to FIG. 4 and FIG. 5, an orthographic projection of the second via hole VH2 on the base substrate 1 falls within an orthographic projection of the first via hole VH1 on the base substrate 1. At least one of the orthographic projection of the first via hole VH1 on the base substrate 1 and the orthographic projection of the second via hole VH2 on the base substrate 1 falls within the orthographic projection of the terminal 2 on the base substrate 1. For example, each of the orthographic projection of the first via hole VH1 on the base substrate 1 and the orthographic projection of the second via hole VH2 on the base substrate 1 falls within the orthographic projection of the terminal 2 on the base substrate 1. The second via hole VH2 exposes at least part of an upper surface of the terminal 2, so that the signal wire 3 formed in subsequent sputtering and etching processes may come into contact with the exposed upper surface of the terminal 2, thereby an electrical connection between the terminal 2 and the signal wire 3 may be formed.

In the embodiments of the present disclosure, the terminal 2 includes a first terminal portion 21 located in the first conductive layer 11 and a second terminal portion 22 located in the second conductive layer 12. For example, the first terminal portion 21 includes a source or drain material, and the second terminal portion 22 includes a material with a high conductivity such as copper. The terminal 2 includes a stack structure, and in particular, an upper layer includes a material with a high conductivity such as copper, which may help reduce a contact resistance of the terminal 2 when the terminal 2 comes into contact with the signal wire 3, and improve an electrical connection performance between the two.

Continuing to refer to FIG. 4 and FIG. 5, the plurality of conductive pads 121 include a first conductive pad 121A closest to the side edge 1S of the base substrate 1. An orthographic projection of the first conductive pad 121A on the base substrate 1 has a first side edge 121AS close to the side edge 1S of the base substrate 1, the orthographic projection of the first planarization layer PLN1 on the base substrate 1 has a first side edge PLN1S close to the side edge 1S of the base substrate 1, and the orthographic projection of the second planarization layer PLN2 on the base substrate 1 has a first side edge PLN2S close to the side edge 1S of the base substrate 1. That is to say, the first side edge 121AS of the orthographic projection of the first conductive pad 121A on the base substrate 1 is a side edge facing the terminal 2 among a plurality of side edges of the orthographic projection of the first conductive pad 121A on the base substrate 1, the first side edge PLN1S of the orthographic projection of the first planarization layer PLN1 on the base substrate 1 is a side edge facing the terminal 2 among a plurality of side edges of the orthographic projection of the first planarization layer PLN1 on the base substrate 1, and the first side edge PLN2S of the orthographic projection of the second planarization layer PLN2 on the base substrate 1 is a side edge facing the terminal 2 among a plurality of side edges of the orthographic projection of the second planarization layer PLN2 on the base substrate 1.

The orthographic projection of the terminal 2 on the base substrate 1 has a first side edge 2S away from the side edge 1S of the base substrate 1, that is, the first side edge 2S of the orthographic projection of the terminal 2 on the base substrate 1 is a side edge farthest away from the side edge 1S of the base substrate 1 in the first direction D1 among a plurality of side edges of the orthographic projection of the terminal 2 on the base substrate 1. The first direction D1 is perpendicular to the side edge 1S of the base substrate 1.

In the embodiments of the present disclosure, the first side edge PLN2S of the orthographic projection of the second planarization layer PLN2 on the base substrate 1 is closer to the terminal 2 than the first side edge 121AS of the orthographic projection of the first conductive pad 121A on the base substrate 1. That is to say, the first side edge PLN2S of the orthographic projection of the second planarization layer PLN2 on the base substrate 1 is closer to the side edge 1S of the base substrate 1 than the first side edge 121AS of the orthographic projection of the first conductive pad 121A on the base substrate 1. Exemplarily, the first side edge PLN2S of the orthographic projection of the second planarization layer PLN2 on the base substrate 1 includes a first side edge portion PLN2S1, which is a portion of the first side edge PLN2S of the second planarization layer directly opposite to the terminal 2. The first side edge 121AS of the orthographic projection of the first conductive pad 121A on the base substrate 1 is spaced apart from the first side edge portion PLN2S 1 of the first side edge of the orthographic projection of the second planarization layer on the base substrate by a first specified distance A1 in the first direction D1.

The first side edge PLN1S of the orthographic projection of the first planarization layer PLN1 on the base substrate 1 includes a first side edge portion PLN1S1, which is a portion of the first side edge PLN1S of the first planarization layer directly opposite to the terminal 2. In the embodiments of the present disclosure, the first side edge portion PLN1S1 of the first side edge of the orthographic projection of the first planarization layer on the base substrate 1 is closer to the terminal 2 than the first side edge portion PLN2S1 of the first side edge of the orthographic projection of the second planarization layer on the base substrate. In other words, the first side edge portion PLN1S1 of the first side edge of the orthographic projection of the first planarization layer on the base substrate 1 is closer to the side edge 1S of the base substrate 1 than the first side edge portion PLN2S1 of the first side edge of the orthographic projection of the second planarization layer on the base substrate.

Exemplarily, the first side edge portion PLN1S1 of the first side edge of the orthographic projection of the first planarization layer on the base substrate is spaced apart from the first side edge portion PLN2S1 of the first side edge of the orthographic projection of the second planarization layer on the base substrate by a second specified distance A2 in the first direction D1.

The first side edge portion PLN1S1 of the first side edge of the orthographic projection of the first planarization layer on the base substrate is spaced apart from the first side edge 2S of the orthographic projection of the terminal on the base substrate by a third specified distance A3 in the first direction D1.

In the embodiments of the present disclosure, the third specified distance A3 is greater than the first specified distance A1; and/or the first specified distance A1 is greater than the second specified distance A2.

Exemplarily, the first distance A1 is related to factors such as process deviations and alignment deviations when forming the first conductive pad and the second planarization layer, the second distance A2 is related to factors such as process deviations and alignment deviations when forming the first planarization layer and the second planarization layer, and the third distance A3 is related to factors such as process deviations, alignment deviations, and the sputtering process when forming the second terminal portion and the first planarization layer.

In some exemplary embodiments, the first specified distance A1, the second specified distance A2, and the third specified distance A3 may meet the following requirements:

$$A1+A2+A3=(PD-L1) \div 2-L2-L3-L4,$$

where PD represents a pitch of pixel units in the first direction, L1 represents a size of the light emitting diode in the first direction, L2 represents a size of a splicing seam in the first direction, L3 represents an edge grinding distance in the first direction, and L4 represents a size of the terminal 2 in the first direction.

It should be noted that as shown in FIG. 4 and FIG. 5, a region between the segment difference of the planarization layer and the side edge 1S of the base substrate 1 may be defined as a terminal region, which includes a terminal and sputtering regions on two sides of the terminal.

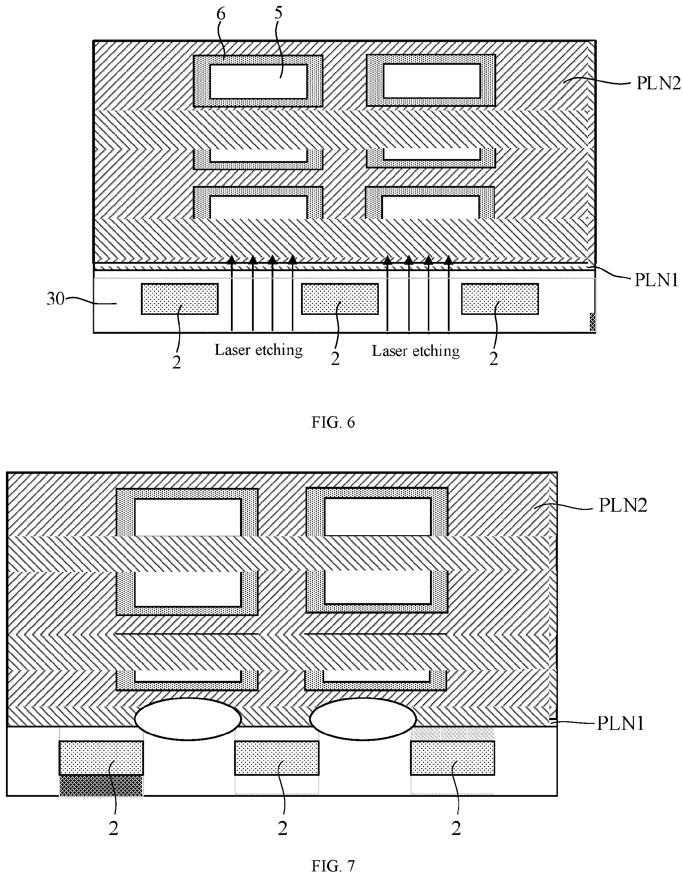

FIG. 6 and FIG. 7 respectively show schematic plan views of a display panel during processing according to some exemplary embodiments of the present disclosure, in which FIG. 6 schematically shows a partial plan view of a display panel after the sputtering process and before the laser etching process, and FIG. 7 schematically shows a partial plan view of a display panel after the laser etching process.

Referring to FIG. 6 and FIG. 7, in the sputtering process, a metal layer 30, such as a Ti/Cu/Ti metal layer, may be plated on the terminal region, the side surface of the display panel, and the fan-out region on the back surface of the display panel. In the laser etching process, it is needed to etch the metal layer 30 between terminals 2 so as to remove a metal material between the terminals 2. In the laser etching process, in order to ensure that the metal layer between terminals 2 is fully etched off and to ensure that there is no short circuit between terminals 2, the laser etching process may be performed for a long time. The inventors found through research that in some cases, there is a risk of the laser etching affecting the planarization layer at the edge. For example, such case is schematically shown in in FIG. 7. The etching laser may irradiate the planarization layer, which may cause the edge of the planarization layer being burned, and result in a potential risk of the conductive pad being exposed.

It should be noted that FIG. 7 is just exemplary and is intended to illustrate that there is a risk that the edge of the planarization layer being burned. However, this may not be regarded as a limitation to the embodiments of the present disclosure. In the embodiments of the present disclosures, there are also cases where the edge of the planarization layer may not be damaged or burned in the laser etching process, as shown in FIG. 4 and FIG. 5.

In some exemplary embodiments of the present disclosure, the planarization layer may be used for a dam design between terminals 2. For example, the first planarization layer PLN1 and the second planarization layer PLN2 may extend between the terminals 2 to form a dam. In the laser etching process, the dam may act as a buffer to protect the conductive pad of the light emitting diode from an influence of laser etching.

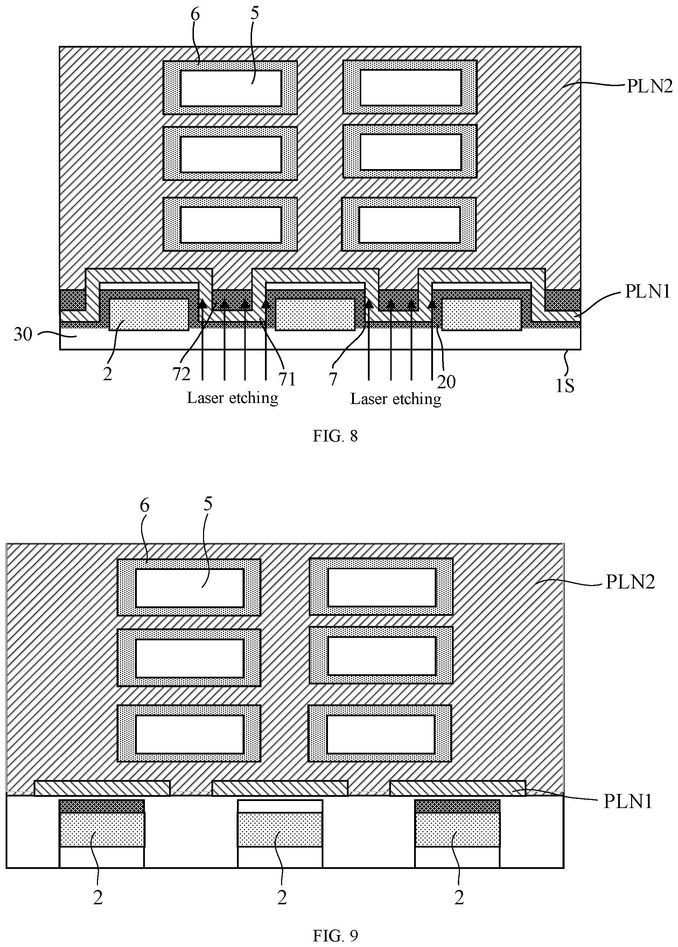

FIG. 8 shows a partial plan view of a display panel according to some exemplary embodiments of the present disclosure, in which a dam design is schematically shown. FIG. 9 shows a partial plan view of a display panel after the laser etching process according to some exemplary embodiments of the present disclosure. Referring to FIG. 8 and FIG. 9, the display panel 100 includes a plurality of terminals 2, and a gap 20 is formed between the plurality of terminals 2. The display panel 100 includes a first dam 7 directly opposite to the gap 20 in the first direction D1. An orthographic projection of at least part of the first dam 7 on the base substrate 1 protrudes toward the gap 20 in the first direction D1 relative to the first side edge portion PLN1S1 of the first side edge of the orthographic projection of the first planarization layer PLN1 on the base substrate 1.

For example, the first dam 7 may be formed by a portion of the planarization layer, and the first dam 7 is closer to the side edge 1S of the base substrate 1 than other portions of the planarization layer. Specifically, the first dam 7 includes a first dam portion 71 located in the first planarization layer PLN1 and a second dam portion 72 located in the second planarization layer PLN2. The first dam portion 71 is a portion that extends continuously with a portion of the first planarization layer PLN1 located in the display region AA, and the second dam portion 72 is a portion that extends continuously with a portion of the second planarization layer PLN2 located in the display region. An orthographic projection of the second dam portion 72 on the base substrate 1 falls within an orthographic projection of the first dam portion 71 on the base substrate 1.

Referring to FIG. 8 and FIG. 9, a gap 20 is formed between any two adjacent terminals 2, that is, the display panel 100 includes a plurality of gaps 20. Accordingly, the display panel 100 includes a plurality of first dams 7 respectively arranged opposite to the plurality of gaps 20.

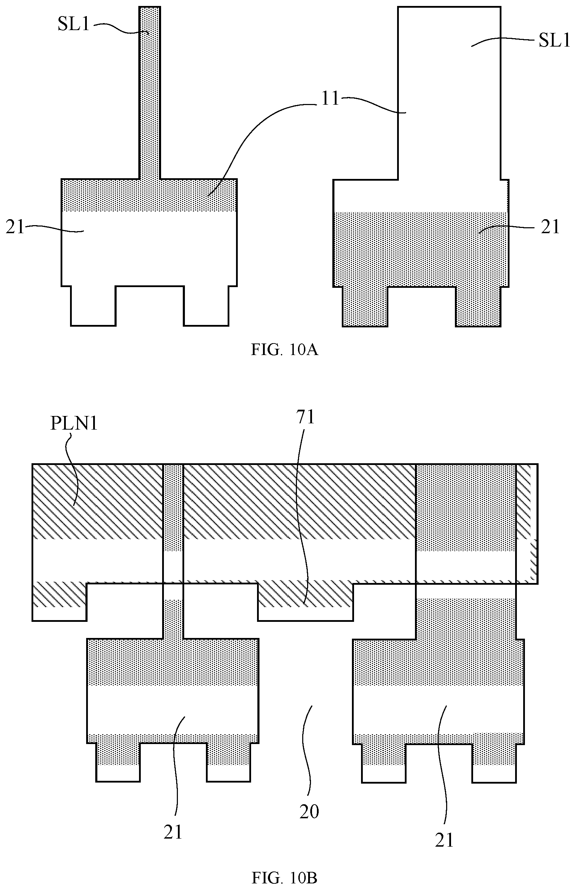

FIG. 10A to FIG. 10F respectively show schematic diagrams of an intermediate structure of the display panel having the dam design shown in FIG. 8, in which FIG. 10A to FIG. 10F schematically show structures of the display panel located in the terminal region and the display region adjacent to the terminal region.

Referring to FIG. 10A, a first conductive layer 11 is patterned to form a first terminal portion 21 in the terminal region and a first wire SL1 in the terminal region and the display region. The first wire SL1 extends from the first terminal portion 21 toward the display region AA.

Referring to FIG. 10B, a first planarization layer PLN1 is formed, including a portion located in the display region AA and a first dam portion 71 of the first dam 71 located in the terminal region. The first dam portion 71 protrudes toward the side edge 1S of the base substrate 1 relative to the portion of the first planarization layer PLN1 located in the display region AA.

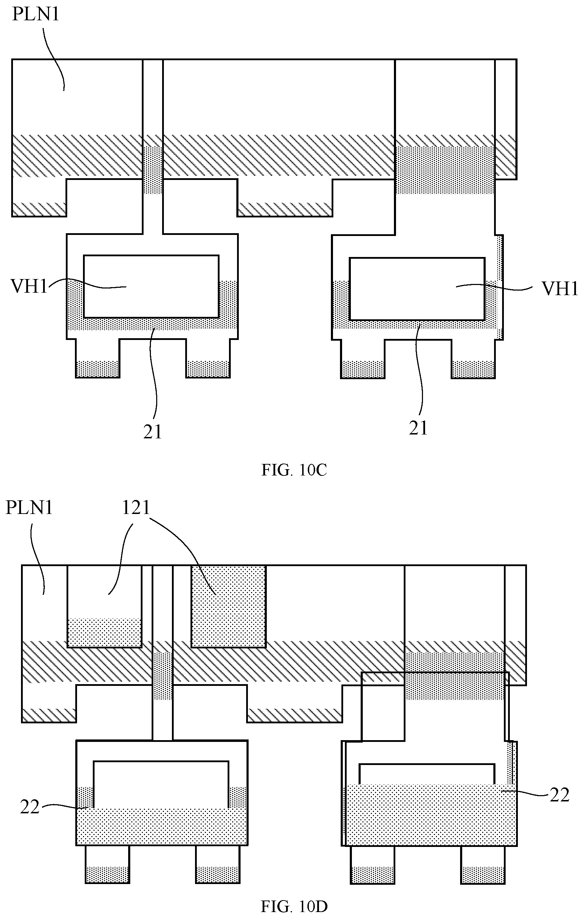

Referring to FIG. 10C, a first passivation layer PVX1 is formed on a side of the first planarization layer PLN1 away from the base substrate, and a first via hole VH1 is formed in the first passivation layer PVX1. An orthographic projection of the first via hole VH1 on the base substrate 1 falls within an orthographic projection of the first terminal portion 21 on the base substrate 1, that is, the first via hole VH1 exposes a portion of an upper surface of the first terminal portion 21.

Referring to FIG. 10D, a second conductive layer 12 is formed on a side of the first passivation layer PVX1 away from the base substrate, and the second conductive layer 12 is patterned to form a second terminal portion 22 in the terminal region and conductive pads 121 in the display region. The second terminal portion 22 is in contact with the lower first terminal portion 21 through the first via hole VH1.

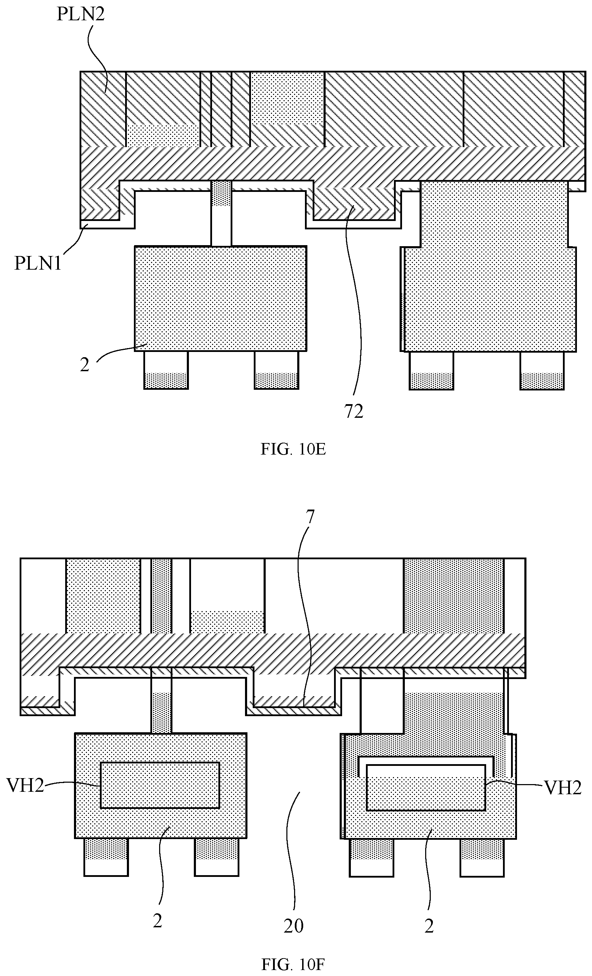

Referring to FIG. 10E, a second planarization layer PLN2 is formed on a side of the second conductive layer 12 away from the base substrate. The second planarization layer PLN2 includes a portion located in the display region AA and a second dam portion 72 of the first dam 7 located in the terminal region. The second dam portion 72 protrudes toward the side edge 1S of the base substrate 1 relative to the portion of the second planarization layer PLN2 located in the display region AA. An orthographic projection of the second planarization layer PLN2 including the second dam portion 72 on the base substrate 1 still falls within an orthographic projection of the first planarization layer PLN1 including the first dam portion 71 on the base substrate 1. In this way, the second dam portion 72 may be avoided to form at a segment difference of the first planarization layer PLN1.

Referring to FIG. 10F, a second passivation layer PVX2 is formed on a side of the second planarization layer PLN2 away from the base substrate, and a second via hole VH2 is formed in the second passivation layer PVX2. An orthographic projection of the second via hole VH2 on the base substrate 1 falls within an orthographic projection of the second terminal portion 22 on the base substrate 1, that is, the second via hole VH2 exposes a portion of an upper surface of the second terminal portion 22.

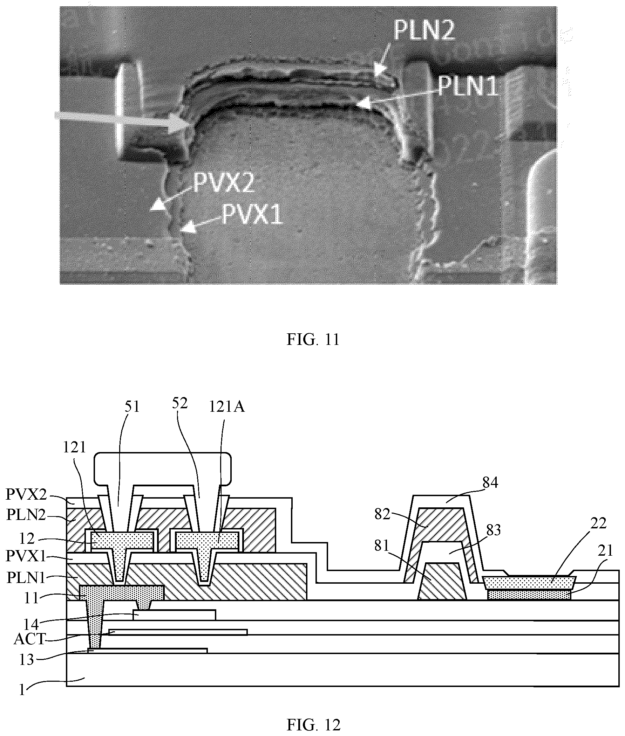

Referring to FIG. 8 and FIG. 9, in the laser etching process, the first dam 7 may act as a buffer to protect the conductive pad of the light emitting diode from the influence of laser etching. FIG. 11 shows an SEM image of a display panel with a dam design after the laser etching process. As shown in FIG. 11, in the scanning electron microscope image, it is clearly shown that laser etching has etched a part of the first dam 7. Under a protection of the first dam 7, the laser etching does not further damage the planarization layer in the display region or the conductive pad of the light emitting diode.

Continuing to refer to FIG. 11, after the laser etching, only a portion of the first dam 7 is etched off, while at least part of the first dam is still retained. That is to say, after the laser etching, the display panel 100 still includes the first dam 7, and an orthographic projection of at least part of the first dam 7 on the base substrate 1 protrudes toward the gap 20 in the first direction D1 relative to the first side edge portion PLN1S1 of the first side edge of the orthographic projection of the first planarization layer PLN1 on the base substrate 1.

In some exemplary embodiments, a ratio of a size of the first dam 7 in the second direction D2 to a size of the gap 20 directly opposite to the first dam 7 in the second direction D2 is in a range from 0.6 to 1.5. The second direction D2 is perpendicular to the first direction D1. For example, the second direction D2 is parallel to the side edge 1S of the base substrate. For example, the size of the first dam 7 in the second direction D2 is less than the size of the gap 20 in the second direction D2. For example, a size of the second dam portion 72 in the second direction D2 is less than a size of the first dam portion 71 in the second direction D2.

In the embodiments of the present disclosure, a height of the first dam 7 protruding toward the gap 20 (i.e., a size of the first dam 7 in the first direction D1) is related to an etching damage to the planarization layer caused by the laser etching. That is to say, the height of the first dam 7 protruding toward the gap 20 is designed such that the laser etching does not damage the planarization layer located in the display region AA. In some examples, the first dam 7 does not extend into the gap 20 in the first direction D1. For example, an orthographic projection of the first dam 7 in the first direction D1 does not overlap with an orthographic projection of the terminal 2 in the first direction D1. Specifically, the size of the second dam portion 72 in the first direction D1 is less than the size of the first dam portion 71 in the first direction D1.

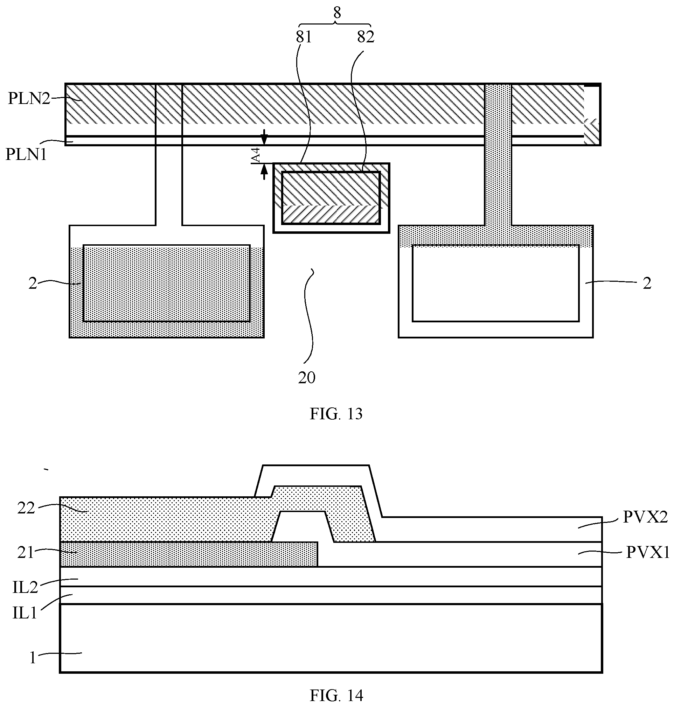

FIG. 12 shows a cross-sectional view of a display panel according to some exemplary embodiments of the present disclosure, and FIG. 13 shows a partial plan view of a display panel according to some exemplary embodiments of the present disclosure, in which FIG. 12 and FIG. 13 schematically show another dam design. Referring to FIG. 12 and FIG. 13, the display panel 100 includes a plurality of terminals 2, and a gap 20 is formed between the plurality of terminals 2. The display panel 100 includes a second dam 8 directly opposite to the gap 20 in the first direction D1. The second dam 8 is spaced apart from the portion of the first planarization layer PLN1 located in the display region AA, and the second dam 8 is closer to the gap 20 than the portion of the first planarization layer PLN1 located in the display region AA. The second dam 8 is spaced apart from the portion of the second planarization layer PLN2 located in the display region AA, and the second dam 8 is closer to the gap 20 than the portion of the second planarization layer PLN2 located in the display region AA.

In the embodiments of the present disclosure, the second dam 8 includes a first sub-dam 81 located in the first planarization layer PLN1 and a second sub-dam 82 located in the second planarization layer PLN2. An orthographic projection of the second sub-dam 82 on the base substrate 1 falls within an orthographic projection of the first sub-dam 81 on the base substrate 1.

Referring to FIG. 12, the second dam 8 further includes a third sub-dam 83 located in the first passivation layer PVX1 and a fourth sub-dam 84 located in the second passivation layer PVX2. The first sub-dam 81 is spaced apart from the portion of the first planarization layer PLN1 located in the display region AA. The second sub-dam 82 is spaced apart from the portion of the second planarization layer PLN2 located in the display region AA. The third sub-dam 83 is a portion that extends continuously with the portion of the first passivation layer PVX1 located in the display region AA. The fourth sub-dam 84 is a portion that extends continuously with the portion of the second passivation layer PVX2 located in the display region AA.

In the embodiments shown in FIG. 12 and FIG. 13, a body portion of the second dam 8 includes a portion located in the first planarization layer PLN1 and a portion located in the second planarization layer PLN2. The portion of the second dam 8 located in the first planarization layer PLN1 is spaced apart from the portion of the first planarization layer PLN1 located in the display region AA, that is, the two are discontinuous; the portion of the second dam 8 located in the second planarization layer PLN2 is spaced apart from the portion of the second planarization layer PLN2 located in the display region AA, that is, the two are discontinuous. The first passivation layer PVX1 and the second passivation layer PVX2 are stilled arranged in a gap between the portion of the first planarization layer PLN1 located in the display region AA and the second dam 8 and in a gap between the portion of the second planarization layer PLN2 located in the display region AA and the second dam 8. Through such design, even if a part of the second dam 8 is etched off in the laser etching process, the two planarization layers located in the display region AA may still be protected by corresponding passivation layers. In this way, in a reliability test, water vapor may be avoided from entering an interior of the display panel along the planarization layer, so that the reliability of the display panel may be improved, and a yield of the display panel may be improved.

Referring to FIG. 12 and FIG. 13, the first sub-dam 81 is spaced apart from the portion of the first planarization layer PLN1 located in the display region AA by a fourth specified distance A4. That is to say, a vertical distance, between the first side edge PLN1S of the orthographic projection of the first planarization layer PLN1 on the base substrate 1 and a first side 811 of an orthographic projection of the first sub-dam 81 on the base substrate 1 that is close to the first side edge PLN1S, is the fourth specified distance A4. The fourth specified distance A4 is designed such that the first sub-dam 81 may be spaced apart from the planarization layer located in the display region AA when taking process factors into account. The fourth specified distance is related to process deviations and alignment deviations of the first planarization layer PLN1 and the second planarization layer PLN2.

A size of the second sub-dam 82 in the first direction D1 is related to an etching damage to the planarization layer caused by the laser etching. That is to say, the size of the second sub-dam 82 in the first direction D1 is designed such that the laser etching does not damage the planarization layer located in the display region AA. In some examples, the second dam 8 extends into the gap 20 in the first direction D1. For example, an orthographic projection of the second dam 8 in the first direction D1 overlaps partially with the orthographic projection of the terminal 2 in the first direction D1. Specifically, the size of the second sub-dam 82 in the first direction D1 is less than a size of the first sub-dam 81 in the first direction D1.

In some exemplary embodiments, a ratio of a size of the second dam 8 in the second direction D2 to a size of the gap 20 directly opposite to the second dam 8 in the second direction D2 is in a range from 0.6 to 1.

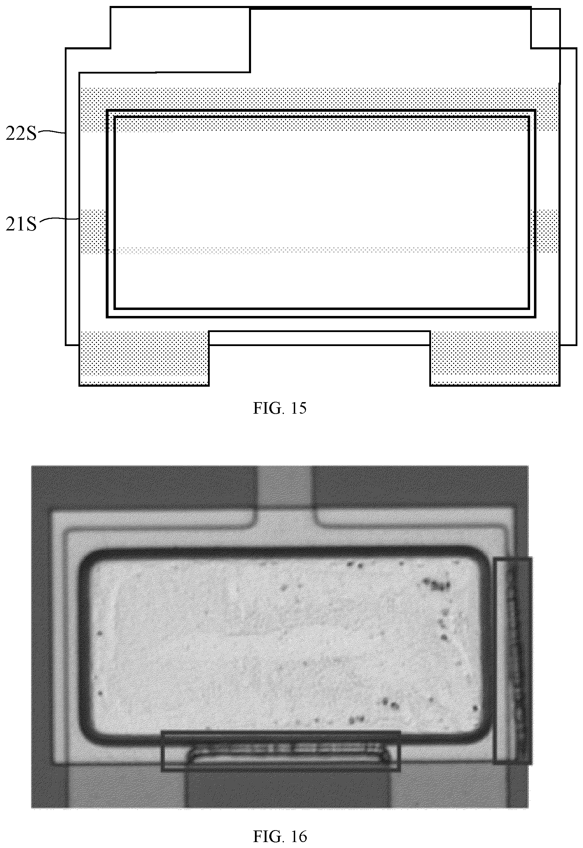

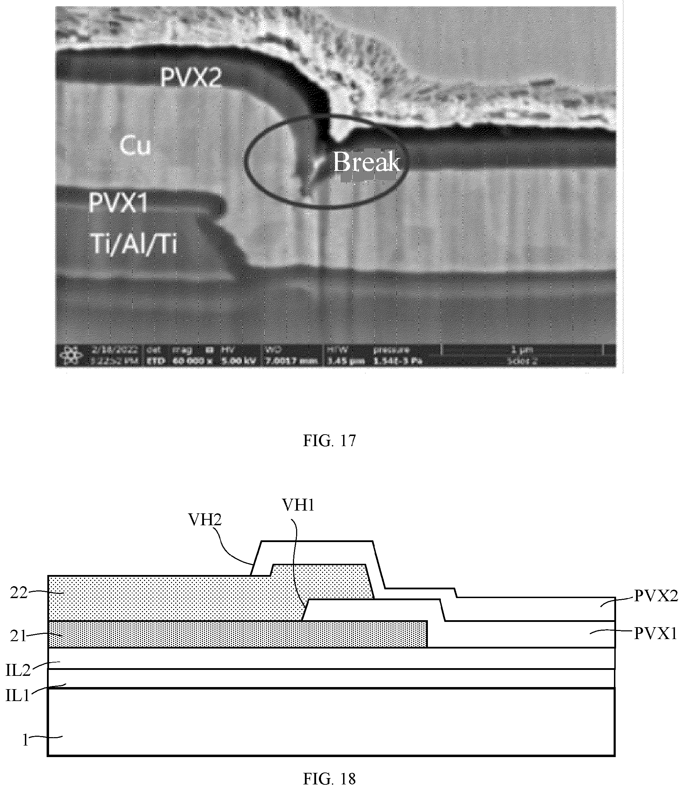

FIG. 14 shows a cross-sectional view of a display panel at a terminal according to some exemplary embodiments of the present disclosure. FIG. 15 shows a plan view of a display panel at a terminal according to some exemplary embodiments of the present disclosure. FIG. 16 shows a photo of a structure of a display panel at a terminal formed after an electroless nickel immersion gold process according to some exemplary embodiments of the present disclosure. FIG. 17 shows an SEM image of a display panel at a terminal according to some exemplary embodiments of the present disclosure.

Referring to FIG. 14 and FIG. 15 in combination, in the middle of the terminal 2, a film layer structure from bottom to top includes: a portion of the first insulation layer IL1 located on the base substrate 1, a portion of the second insulation layer IL2 located on the first insulation layer IL1, the first terminal portion 21 located in the first via hole VH1, and the second terminal portion 22 located in the second via hole VH2. At the edge of the terminal 2A, a film layer structure from bottom to top includes: a portion of the first insulation layer IL1 located on the base substrate 1, a portion of the second insulation layer IL2 located on the first insulation layer IL1, the first terminal portion 21 located in the first via hole VH1, a portion of the first passivation layer PVX1 covering an edge of the first terminal portion 21, the second terminal portion 22 located in the second via hole VH2, and a portion of the second passivation layer PVX2 covering an edge of the second terminal portion 22.

In the embodiments, the orthographic projection of the second terminal portion 22 on the base substrate 1 covers the orthographic projection of the first terminal portion 21 on the base substrate 1. Specifically, the orthographic projection of the first terminal portion 21 on the base substrate 1 has a first side edge 21S, and the orthographic projection of the second terminal portion 22 on the base substrate 1 has a first side edge 22S. The first side edge 22S of the orthographic projection of the second terminal portion on the base substrate 1 and the first side edge 21S of the orthographic projection of the first terminal portion on the base substrate 1 are side edges on a same side of orthographic projections of the two terminal portions on the base substrate. For example, in the embodiments shown in FIG. 15, the first side edge 22S of the orthographic projection of the second terminal portion on the base substrate and the first side edge 21S of the orthographic projection of the first terminal portion on the base substrate are left sides, right sides or lower sides of the orthographic projections of the two terminal portions on the base substrate. The first side edge 22S of the orthographic projection of the second terminal portion on the base substrate is further outward than the first side edge 21S of the orthographic projection of the first terminal portion on the base substrate.

The inventors found through research that since the second terminal portion 22 located on the upper layer covers the first terminal portion 21 located on the lower layer at the edge of the terminal 2, the second terminal portion 22 has a climbing structure at the edge of the first terminal portion 21, as shown in FIG. 14. The second passivation layer PVX2 above the second terminal portion 22 is thin, and the climbing structure of the second terminal portion 22 may cause the second passivation layer PVX2 at edges of the terminal 2 to break or crack at the climbing structure, as shown in FIG. 17. Since a subsequent electroless nickel immersion gold process is a chemical reaction in a liquid state, a liquid may permeate from the crack to a surface of the second terminal portion 22, then a reaction may occur, and a nickel-gold wire may grow at the crack, as shown in FIG. 16. Such nickel-gold wire is extremely prone to falling off and randomly entering the display region, which brings risks such as short circuits.

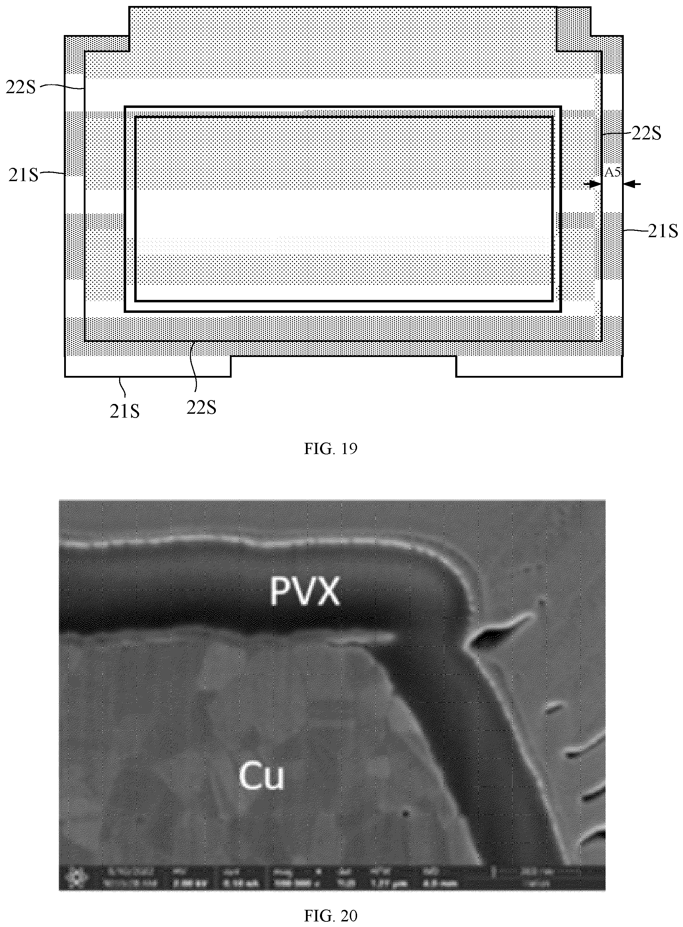

FIG. 18 shows a cross-sectional view of a display panel at a terminal according to other exemplary embodiments of the present disclosure. FIG. 19 shows a plan view of a display panel at a terminal according to other exemplary embodiments of the present disclosure. FIG. 20 shows an SEM image of a display panel at a terminal according to other exemplary embodiments of the present disclosure.

Referring to FIG. 18 and FIG. 19, in the middle of the terminal 2, a film layer structure from bottom to top includes: a portion of the first insulation layer IL1 located on the base substrate 1, a portion of the second insulation layer IL2 located on the first insulation layer IL1, the first terminal portion 21 located in the first via hole VH1, and the second terminal portion 22 located in the second via hole VH2. At the edge of the terminal 2, a film layer structure from bottom to top includes: a portion of the first insulation layer IL1 located on the base substrate 1, a portion of the second insulation layer IL2 located on the first insulation layer IL1, the first terminal portion 21 located in the first via hole VH1, a portion of the first passivation layer PVX1 covering an edge of the first terminal portion 21, the second terminal portion 22 located in the second via hole VH2, and a portion of the second passivation layer PVX2 covering an edge of the second terminal portion 22.

In the embodiments, the orthographic projection of the second terminal portion 22 on the base substrate 1 falls within the orthographic projection of the first terminal portion 21 on the base substrate 1. Specifically, the orthographic projection of the first terminal portion 21 on the base substrate 1 has a first side edge 21S, and the orthographic projection of the second terminal portion 22 on the base substrate 1 has a first side edge 22S. The first side edge 22S of the orthographic projection of the second terminal portion on the base substrate and the first side edge 21S of the orthographic projection of the first terminal portion on the base substrate are side edges on a same side of orthographic projections of the two terminal portions on the base substrate. For example, in the embodiments shown in FIG. 19, the first side edge 22S of the orthographic projection of the second terminal portion on the base substrate and the first side edge 21S of the orthographic projection of the first terminal portion on the base substrate are left sides, right sides or lower sides of the orthographic projections of the two terminal portions on the base substrate.

In such embodiments, the orthographic projection of the second via hole VH2 on the base substrate 1 falls within the orthographic projection of the second terminal portion 22 on the base substrate 1, and a portion of the second passivation layer PVX2 covers the side edge of the second terminal portion 22. The orthographic projection of the first via hole VH1 on the base substrate 1 falls within the orthographic projection of the first terminal portion 21 on the base substrate 1, and a portion of the first passivation layer PVX1 covers the side edge of the first terminal portion 21.

The first side edge 21S of the orthographic projection of the first terminal portion on the base substrate is further outward than the first side edge 22S of the orthographic projection of the second terminal portion on the base substrate. In some exemplary embodiments, a vertical distance between the first side edge 22S of the orthographic projection of the second terminal portion on the base substrate and the first side edge 21S of the orthographic projection of the first terminal portion on the base substrate is greater than a fifth specified distance A5. The fifth specified distance A5 is related to process deviations when forming the first terminal portion and the second terminal portion. Considering the process deviations, in order to ensure that the orthographic projection of the second terminal portion 22 on the base substrate 1 always falls within the orthographic projection of the first terminal portion 21 on the base substrate 1, the fifth specified distance A5 may be equal to about 2 microns, that is, the vertical distance between the first side edge 22S of the orthographic projection of the second terminal portion on the base substrate and the first side edge 21S of the orthographic projection of the first terminal portion on the base substrate is greater than 2 microns. For example, the vertical distance between the first side edge 22S of the orthographic projection of the second terminal portion on the base substrate and the first side edge 21S of the orthographic projection of the first terminal portion on the base substrate is greater than 3.5 microns.

Through such design, the second passivation layer PVX2 covering the edge of the second terminal portion 22 may not climb to have a large segment difference, thus avoiding an occurrence of breakage or crack of the second passivation layer PVX2 at the edge of the second terminal portion 22. As shown in FIG. 20, the segment difference at the edge of the second terminal portion 22 is improved, and an overall morphology is smooth. The second passivation layer PVX2 located above the edge of the second terminal portion 22 is smooth without breakage. That is to say, in the subsequent electroless nickel immersion gold process, the possible defects of nickel-gold wire may be avoided.

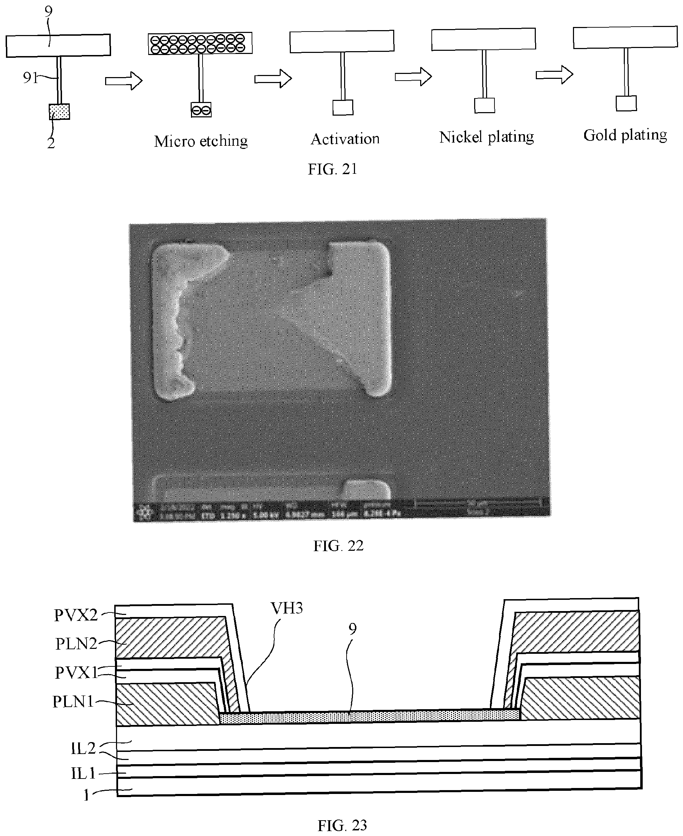

Referring back to FIG. 2, before a motherboard is cut, a region to be cut including the cutting edge is provided on the motherboard, and a width of the region to be cut is related to factors of cutting processes. At least part of a test unit CT may be provided in the region to be cut. When testing the display panel, a test wire 91 (referring to FIG. 21) may be led out from the terminal 2 to the test unit, and the test unit may be used for yield screening of the display panel. For example, the test unit may include a plurality of test terminals 9, and the test terminal may include a conductive metal material such as Ti/Al/Ti.

The inventors found through research that an orthographic projection of the test terminal 9 on the base substrate 1 has a larger area than the orthographic projection of the terminal 2 on the base substrate 1. Moreover, in order to facilitate contact between the test terminal 9 and the test wire, it is needed to expose most of an upper surface of the test terminal 9. In this case, the mostly exposed test terminal 9 may have an adverse effect on the electroless nickel immersion gold process of the terminal 2. FIG. 21 schematically shows a process of a test terminal reacting with a terminal during an electroless nickel immersion gold process on the display panel. FIG. 22 shows an SEM image of a terminal formed after the process shown in FIG. 21 is executed. FIG. 23 shows a cross-sectional view of the display panel at a test terminal before executing an electroless nickel immersion gold process on the display panel. Referring to FIG. 21 and FIG. 23, in a region where the test terminal 9 is located, a film layer structure from bottom to top includes: a portion of the first insulation layer IL1 located on the base substrate 1, a portion of the second insulation layer IL2 located on the first insulation layer IL1, the test terminal 9 located in a third via hole VH3, a portion of the first planarization layer PLN1 located on a side of the test terminal 9 away from the base substrate, a portion of the first passivation layer PVX1 located on a side of the first planarization layer PLN1 away from the base substrate, a portion of the second planarization layer PLN2 located on a side of the first passivation layer PVX1 away from the base substrate, and a portion of the second passivation layer PVX2 on a side of the first planarization layer PLN1 away from the base substrate. That is to say, the test terminal 9 and the first terminal portion 21 of the terminal 2 may be located in the same layer, that is, the test terminal 9 may include a source or drain material, such as Ti/Al/Ti. The third via hole VH3 exposes at least part of the upper surface of the test terminal 9.

The exposed upper surface of the test terminal 9 includes a large area of Ti/Al/Ti, and the exposed upper surface of the terminal 2 includes a small area of Cu. Ti/Al/Ti, as a surface metal of the test terminal, is highly active, and a displacement reaction is more likely to occur in the electroless nickel immersion gold process. Specifically, referring to FIG. 21, during a micro-etching process of the electroless nickel immersion gold process, Ti in the large area of Ti/Al/Ti is more likely to lose electrons than the small area of Cu. During an activation process of the electroless nickel immersion gold process, the surface of the test terminal 9 has a large electron density, and a palladium complex is easier to obtain electrons and activates onto the surface of the test terminal 9. During a nickel plating process of the electroless nickel immersion gold process, the nickel plating on the terminal 2 is relatively difficult because the terminal 2 obtains little palladium during the activation process. During a gold plating process of the electroless nickel immersion gold process, due to the difficulty of nickel plating on the terminal 2, the gold plating on the terminal 2 is difficult, which ultimately results in leakage of plating on the upper surface of the terminal 2. As shown in FIG. 22, after the electroless nickel immersion gold process, nickel-gold is only formed on a portion of the upper surface of the terminal 2, but missing in a large area.

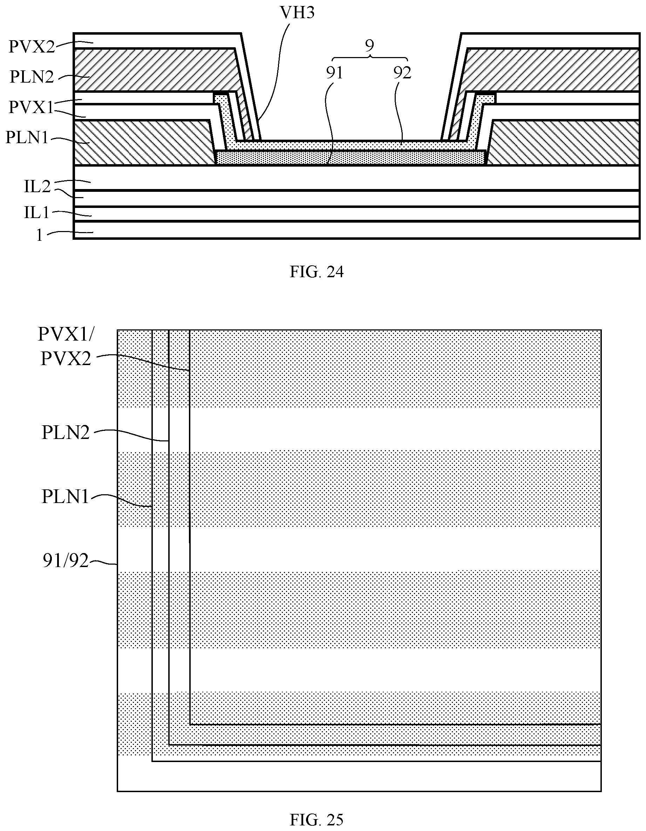

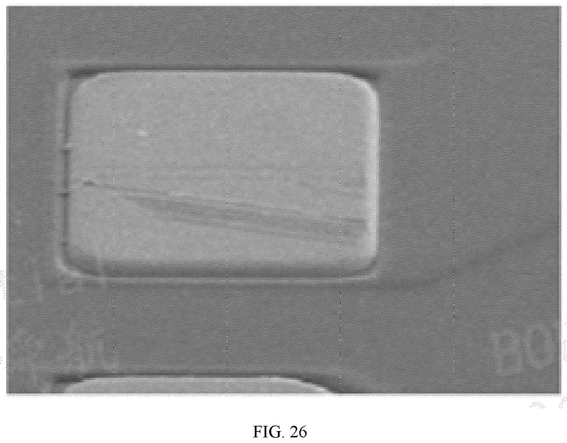

FIG. 24 shows a cross-sectional view of the display panel at a test terminal before executing an electroless nickel immersion gold process on the display panel. FIG. 25 shows a plan view of the display panel shown in FIG. 24. FIG. 26 shows an SEM image of a terminal of a display panel having the structure shown in FIG. 24.

Referring to FIG. 24 and FIG. 25, in a region where the test terminal 9 is located, a film layer structure from bottom to top includes: a portion of the first insulation layer IL1 located on the base substrate 1, a portion of the second insulation layer IL2 located on the first insulation layer IL1, a first portion of the test terminal 9 located in the third via hole VH3, a portion of the first planarization layer PLN1 located on a side of the first portion of the test terminal 9 away from the base substrate; a portion of the first passivation layer PVX1 located on a side of the first planarization layer PLN1 away from the base substrate, a second portion of the second test terminal 9 located on a side of the first passivation layer PVX1 away from the base substrate, a portion of the second planarization layer PLN2 located on a side of the second portion of the test terminal 9 away from the base substrate, and a portion of the second passivation layer PVX2 located on a side of the first passivation layer PVX1 away from the base substrate. That is to say, in the embodiments, the test terminal 9 includes two portions, namely the first portion and the second portion mentioned above. Herein, the first portion of the test terminal 9 may be referred to as a first test terminal portion 91, and the second portion of the test terminal 9 may be referred to as a second test terminal portion 92. The first test terminal portion 91 and the first terminal portion 21 of the terminal 2 may be located in the same layer, that is, the first test terminal portion 91 of the test terminal 9 may include a source or drain material, such as Ti/Al/Ti. The second test terminal portion 92 and the second terminal portion 22 of the terminal 2 may be located in the same layer, that is, the second test terminal portion 92 of the test terminal 9 may include metals such as Cu. The third via hole VH3 exposes at least part of an upper surface of the second test terminal portion 92 of the test terminal 9.

Continuing to refer to FIG. 24 and FIG. 25, an orthographic projection of the second test terminal portion 92 on the base substrate 1 covers an orthographic projection of the first test terminal portion 91 on the base substrate 1. For example, the orthographic projection of the second test terminal portion 92 on the base substrate 1 substantially coincides with the orthographic projection of the first test terminal portion 91 on the base substrate 1. With a sequential coverage of the second passivation layer PVX2, the second planarization layer PLN2, the first passivation layer PVX1 and the first planarization layer PLN1, the second test terminal portion 92 may completely cover the first test terminal portion 91 and effectively prevent process deviations, so that a risk of exposure of the first test terminal portion 91 may be avoided.

As shown in FIG. 26, after the electroless nickel immersion gold process, the nickel-gold layer formed on the terminal 2 is spread out flatly without missing parts, and defects in the entire electroless nickel immersion gold process are effectively solved.

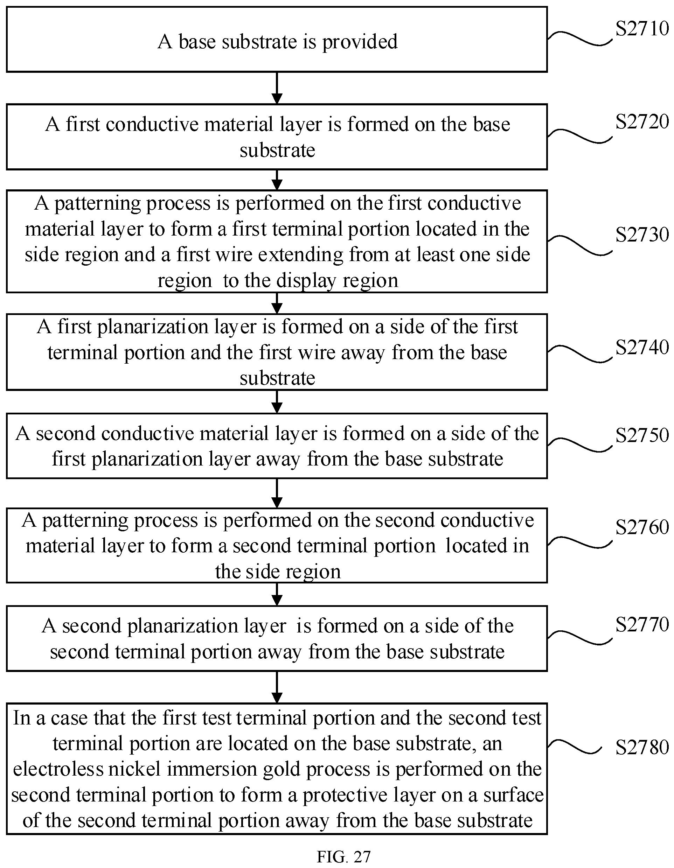

FIG. 27 shows a flowchart of a method of manufacturing a display panel according to the exemplary embodiments of the present disclosure. As shown in FIG. 27, the method may include steps S2710 to S2780.

It should be noted that some steps of the manufacturing method may be executed separately or in combination, and may be executed in parallel or sequentially. A specific operation sequence is not limited to that shown in the drawing.

In step S2710, a base substrate 1 is provided. The base substrate 1 includes a display region AA, a side region NA, and a region to be cut TCA. The side region NA is closer to a side edge of the base substrate than the display region AA, and the region to be cut TCA is closer to the side edge of the base substrate than the side region NA.

In step S2720, a first conductive material layer 11' is formed on the base substrate 1.

In step S2730, a patterning process is performed on the first conductive material layer 11' to form a first terminal portion 21 located in the side region NA and a first wire SL1 extending from at least one side region NA to the display region AA.

In step S2740, a first planarization layer PLN1 is formed on a side of the first terminal portion 21 and the first wire SL1 away from the base substrate 1.

In step S2750, a second conductive material layer 12' is formed on a side of the first planarization layer PLN1 away from the base substrate 1.

In step S2760, a patterning process is performed on the second conductive material layer 12' to form a second terminal portion 22 located in the side region NA.

In step S2770, a second planarization layer PLN2 is formed on a side of the second terminal portion 22 away from the base substrate 1.

In some exemplary embodiments, in step S2730, i.e., in the step of performing a patterning process on the first conductive material layer 11', a first test terminal portion 91 is further formed in the region to be cut; in step S2760, i.e., in the step of performing a patterning process on the second conductive material layer 12', a second test terminal portion 92 is further formed in the region to be cut. An orthographic projection of the second test terminal portion 92 on the base substrate 1 covers an orthographic projection of the first test terminal portion 91 on the base substrate 1.

In step S2780, in a case that the first test terminal portion 91 and the second test terminal portion 92 are located on the base substrate, an electroless nickel immersion gold process is performed on the second terminal portion 22 to form a protective layer on a surface of the second terminal portion 22 away from the base substrate.

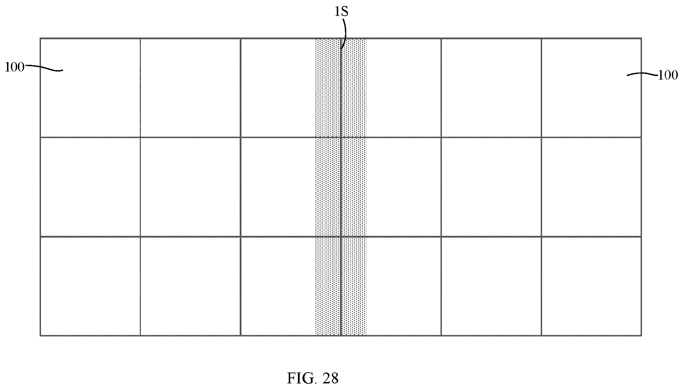

Some exemplary embodiments of the present disclosure further provide a display device. Referring to FIG. 28, the display device includes at least two display substrates as described above. The at least two display substrates as described above are spliced together to form the display device.

It should be understood that the display device according to some exemplary embodiments of the present disclosure may have all characteristics and advantages of the display panel as described above. Those characteristics and advantages may be referred to the above descriptions for the display panel, which will not be repeated here.

Here, the terms "substantially", "about", "approximately" and other similar terms are used as terms of approximation rather than terms of degree, and they are intended to explain an inherent deviation of a measured or calculated value that will be recognized by those ordinary skilled in the art. Taking into account process fluctuations, measurement problems, errors related to a measurement of a specific quantity (that is, a limitation of a measurement system) and other factors, the terms "about" or "approximately" used here includes a stated value and means that a specific value determined by those ordinary skilled in the art is within an acceptable range of deviation. For example, "about" may mean being within one or more standard deviations, or within $\pm 10\%$ or $\pm 5\%$ of the stated value.

Although some embodiments according to the general inventive concept of the present disclosure have been illustrated and explained, it may be understood by those skilled in the art that changes may be made to these embodiments without departing from the principle and spirit of the general inventive concept of the present disclosure, and the scope of the present disclosure is defined by the claims and their equivalents.

**Claims**

1. A display panel, comprising:

   a base substrate comprising at least one side region and a display region, wherein the at least one side region is closer to a side edge of the base substrate than the display region;
   a plurality of pixel units provided in the display region and distributed in an array on the base substrate, wherein at least one pixel unit comprises a light emitting diode and a pixel driving circuit for driving the light emitting diode;
   a terminal provided on the base substrate and located in the side region;
   a first wire provided on the base substrate, wherein the first wire has one end electrically connected to the terminal and the other end electrically connected to the pixel driving circuit; and
   a second wire provided on the base substrate, wherein the second wire has one end electrically connected to the terminal, and the second wire extends in a direction from the terminal to the side edge of the base substrate,

wherein the display panel comprises:

a first conductive layer provided on the base substrate;

a first planarization layer provided on a side of the first conductive layer away from the base substrate;

a second conductive layer provided on a side of the first planarization layer away from the base substrate; and

a second planarization layer provided on a side of the second conductive layer away from the base substrate, and

an orthographic projection of the terminal on the base substrate is spaced apart from an orthographic projection of the first planarization layer on the base substrate, and the orthographic projection of the terminal on the base substrate is spaced apart from an orthographic projection of the second planarization layer on the base substrate.

2. The display panel according to claim 1, wherein in a region between the terminal and the light emitting diode closest to the terminal, the orthographic projection of the second planarization layer on the base substrate falls within the orthographic projection of the first planarization layer on the base substrate.

3. The display panel according to claim 1 or 2, wherein the display panel further comprises a first passivation layer provided between the first planarization layer and the second conductive layer; and in a region between the terminal and the light emitting diode closest to the terminal, the orthographic projection of the first planarization layer on the base substrate falls within an orthographic projection of the first passivation layer on the base substrate.

4. The display panel according to claim 3, wherein the display panel further comprises a second passivation layer provided on a side of the second planarization layer away from the base substrate; and in the region between the terminal and the light emitting diode closest to the terminal, the orthographic projection of the second planarization layer on the base substrate falls within an orthographic projection of the second passivation layer on the base substrate.

5. The display panel according to claim 4, wherein the display panel comprises a first via hole located in the first passivation layer and a second via hole located in the second passivation layer; and

an orthographic projection of the second via hole on the base substrate falls within an orthographic projection of the first via hole on the base substrate, and at least one of the orthographic projection of the first via hole on the base substrate and the orthographic projection of the second via hole on the base substrate falls within the orthographic projection of the terminal on the base substrate.

6. The display panel according to any one of claims 1 to 5, wherein the terminal comprises a first terminal portion located in the first conductive layer and a second terminal portion located in the second conductive layer.

7. The display panel according to any one of claims 1 to 6, wherein the display panel comprises a plurality of conductive pads located in the second conductive layer, and the light emitting diode comprises a first electrode in contact with a conductive pad and a second electrode in contact with another conductive pad; and

the plurality of conductive pads comprise a first conductive pad closest to the side edge of the base substrate, a first side edge of the orthographic projection of the second planarization layer on the base substrate is closer to the terminal than a first side edge of an orthographic projection of the first conductive pad on the base substrate, the first side edge of the orthographic projection of the first conductive pad on the base substrate is a side edge facing the terminal among side edges of the orthographic projection of the first conductive pad on the base substrate, and the first side edge of the orthographic projection of the second planarization layer on the base substrate is a side edge facing the terminal among side edges of the orthographic projection of the second planarization layer on the base substrate.

8. The display panel according to claim 7, wherein the first side edge of the orthographic projection of the second planarization layer on the base substrate comprises a first side edge portion, and the first side edge portion of the second planarization layer is a portion of the first side edge of the second planarization layer directly opposite to the terminal; and

the first side edge of the orthographic projection of the first conductive pad on the base substrate is spaced apart from the first side edge portion of the first side edge of the orthographic projection of the second planarization layer on the base substrate by a first specified distance in a first direction perpendicular to the side edge of the base substrate.

9. The display panel according to claim 8, wherein a first side edge of the orthographic projection of the first planarization layer on the base substrate comprises a first side edge portion, the first side edge of the orthographic projection of the first planarization layer on the base substrate is a side edge facing the terminal among side edges of the orthographic projection of the first planarization layer on the base substrate, and the first side edge portion of the first planarization layer is a portion of the first side edge of the first planarization layer directly opposite to the terminal; and
the first side edge portion of the first side edge of the orthographic projection of the first planarization layer on the base substrate is closer to the terminal than the first side edge portion of the first side edge of the orthographic projection of the second planarization layer on the base substrate.

10. The display panel according to claim 9, wherein the first side edge portion of the first side edge of the orthographic projection of the first planarization layer on the base substrate is spaced apart from the first side edge portion of the first side edge of the orthographic projection of the second planarization layer on the base substrate by a second specified distance in the first direction.

11. The display panel according to claim 10, wherein the first side edge portion of the first side edge of the orthographic projection of the first planarization layer on the base substrate is spaced apart from a first side edge of the orthographic projection of the terminal on the base substrate by a third specified distance in the first direction, and the first side edge of the orthographic projection of the terminal on the base substrate is farthest away from the side edge of the base substrate in the first direction among side edges of the orthographic projection of the terminal on the base substrate.

12. The display panel according to claim 11, wherein the third specified distance is greater than the first specified distance; and/or the first specified distance is greater than the second specified distance.

13. The display panel according to any one of claims 1 to 12, wherein the display panel comprises a plurality of terminals, and a gap is formed between the plurality of terminals;

the display panel comprises a first dam, and the first dam is directly opposite to the gap in the first direction perpendicular to the side edge of the base substrate; and
an orthographic projection of at least part of the first dam on the base substrate protrudes toward the gap in the first direction relative to the first side edge portion of the first side edge of the orthographic projection of the first planarization layer on the base substrate.

14. The display panel according to claim 13, wherein the first dam comprises a first dam portion located in the first planarization layer and a second dam portion located in the second planarization layer; and
the first dam portion is a portion extending continuously with a portion of the first planarization layer located in the display region, and the second dam portion is a portion extending continuously with a portion of the second planarization layer located in the display region.

15. The display panel according to claim 14, wherein an orthographic projection of the second dam portion on the base substrate falls within an orthographic projection of the first dam portion on the base substrate.

16. The display panel according to any one of claims 1 to 12, wherein the display panel comprises a plurality of terminals, and a gap is formed between the plurality of terminals;

the display panel comprises a second dam, and the second dam is directly opposite to the gap in a first direction perpendicular to the side edge of the base substrate;
the second dam is spaced apart from a portion of the first planarization layer located in the display region, and the second dam is closer to the gap than the portion of the first planarization layer located in the display region; and
the second dam is spaced apart from a portion of the second planarization layer located in the display region, and the second dam is closer to the gap than the portion of the second planarization layer located in the display region.

17. The display panel according to claim 16, wherein the second dam comprises a first sub-dam located in the first planarization layer and a second sub-dam located in the second planarization layer; and
an orthographic projection of the second sub-dam on the base substrate falls within an orthographic projection of the first sub-dam on the base substrate.

18. The display panel according to claim 17, wherein the second dam further comprises a third sub-dam located in the first passivation layer and a fourth sub-dam located in the second passivation layer;

the first sub-dam is spaced apart from the portion of the first planarization layer located in the display region;
the second sub-dam is spaced apart from the portion of the second planarization layer located in the display region;
the third sub-dam is a portion extending continuously with a portion of the first passivation layer located in the display region; and

the fourth sub-dam is a portion extending continuously with a portion of the second passivation layer located in the display region.

19. The display panel according to claim 6, wherein an orthographic projection of the second terminal portion on the base substrate falls within an orthographic projection of the first terminal portion on the base substrate.

20. The display panel according to claim 5, wherein the orthographic projection of the second via hole on the base substrate falls within an orthographic projection of a second terminal portion on the base substrate, and a portion of the second passivation layer covers a side edge of the second terminal portion; and/or the orthographic projection of the first via hole on the base substrate falls within an orthographic projection of a first terminal portion on the base substrate, and a portion of the first passivation layer covers a side edge of the first terminal portion.

21. The display panel according to claim 19, wherein a vertical distance between a first side edge of the orthographic projection of the second terminal portion on the base substrate and a first side edge of the orthographic projection of the first terminal portion on the base substrate is greater than 2 microns, and the first side edge of the orthographic projection of the second terminal portion on the base substrate and the first side edge of the orthographic projection of the first terminal portion on the base substrate are side edges on a same side of the orthographic projections of the first and second terminal portions on the base substrate.

22. The display panel according to claim 13, wherein in a second direction perpendicular to the first direction, a ratio of a size of the first dam to a size of the gap directly opposite to the first dam is in a range from 0.6 to 1.5.

23. The display panel according to claim 22, wherein an orthographic projection of the first dam in the first direction does not overlap with an orthographic projection of the terminal in the first direction.

24. The display panel according to claim 16, wherein in a second direction perpendicular to the first direction, a ratio of a size of the second dam to a size of the gap directly opposite to the second dam is in a range from 0.6 to 1.

25. The display panel according to claim 24, wherein an orthographic projection of the second dam in the first direction overlaps partially with an orthographic projection of the terminal in the first direction.

26. A display device, comprising the display panel according to any one of claims 1 to 25.

27. The display device according to claim 26, wherein the display device comprises a plurality of display panels spliced together.

28. A method of manufacturing a display panel, comprising:

providing a base substrate, wherein the base substrate comprises a display region, a side region closer to a side edge of the base substrate than the display region, and a region to be cut closer to the side edge of the base substrate than the side region;
forming a first conductive material layer on the base substrate;
performing a patterning process on the first conductive material layer to form a first terminal portion located in the side region and a first wire extending from at least one side region to the display region;
forming a first planarization layer on a side of the first terminal portion and the first wire away from the base substrate;
forming a second conductive material layer on a side of the first planarization layer away from the base substrate;
performing a patterning process on the second conductive material layer to form a second terminal portion located in the side region; and
forming a second planarization layer on a side of the second terminal portion away from the base substrate,
wherein each of an orthographic projection of the first terminal portion on the base substrate and an orthographic projection of the second terminal portion on the base substrate is spaced apart from an orthographic projection of the first planarization layer on the base substrate, and each of the orthographic projection of the first terminal portion on the base substrate and the orthographic projection of the second terminal portion on the base substrate is spaced apart from an orthographic projection of the second planarization layer on the base substrate.

29. The method according to claim 28, wherein in the step of performing a patterning process on the first conductive material layer, a first test terminal portion is further formed in the region to be cut;

in the step of performing a patterning process on the second conductive material layer, a second test terminal portion is further formed in the region to be cut, and
an orthographic projection of the second test terminal portion on the base substrate covers an orthographic projection of the first test terminal portion on the base substrate.

30. The method according to claim 29, further comprising:

performing an electroless nickel immersion gold process on the second terminal portion to form a protective layer on a surface of the second terminal portion away from the base substrate, in a case that the first test terminal portion and the second test terminal portion are located on the base substrate.

FIG. 1A

Break-up
tab cut

2

1

FIG. 1B

2

1

FIG. 1C

Edge
grinding

2

1

FIG. 1D

FIG. 1E

FIG. 1F

FIG. 1G

FIG. 1H

FIG. 1I

FIG. 1J

FIG. 1K

5

2

Y4

Y3

Y2

After edge
grinding

D1

Cutting edge

Y1

9

9

D2

FIG. 2

100

P

AA

1

NA

D1

1S

2

D2

FIG. 3

<u>100</u>

FIG. 4

FIG. 5

FIG. 6

FIG. 7

FIG. 8

FIG. 9

SL1

21

11

SL1

21

FIG. 10A

PLN1

71

21

20

21

FIG. 10B

PLN1

VH1

21

VH1

21

FIG. 10C

PLN1

121

22

22

FIG. 10D

FIG. 10E

FIG. 10F

FIG. 11

FIG. 12

8
81    82

PLN2

PLN1

A4

2

2

20

FIG. 13

22

21

IL2

IL1

1

PVX2

PVX1

FIG. 14

22S

21S

FIG. 15

FIG. 16

FIG. 17

FIG. 18

FIG. 19

FIG. 20

Micro etching     Activation     Nickel plating     Gold plating

FIG. 21

FIG. 22

FIG. 23

VH3

PVX2

PLN2

PVX1

PLN1

9

91   92

IL2

IL1

1

FIG. 24

PVX1/
PVX2

PLN2

PLN1

91/92

FIG. 25

FIG. 26

A base substrate is provided — S2710

A first conductive material layer is formed on the base substrate — S2720

A patterning process is performed on the first conductive material layer to form a first terminal portion located in the side region and a first wire extending from at least one side region to the display region — S2730

A first planarization layer is formed on a side of the first terminal portion and the first wire away from the base substrate — S2740

A second conductive material layer is formed on a side of the first planarization layer away from the base substrate — S2750

A patterning process is performed on the second conductive material layer to form a second terminal portion located in the side region — S2760

A second planarization layer is formed on a side of the second terminal portion away from the base substrate — S2770

In a case that the first test terminal portion and the second test terminal portion are located on the base substrate, an electroless nickel immersion gold process is performed on the second terminal portion to form a protective layer on a surface of the second terminal portion away from the base substrate — S2780

FIG. 27

FIG. 28

## INTERNATIONAL SEARCH REPORT

| International application No. |
|---|
| **PCT/CN2023/091552** |

### A. CLASSIFICATION OF SUBJECT MATTER

H01L 23/498(2006.01)i

According to International Patent Classification (IPC) or to both national classification and IPC

### B. FIELDS SEARCHED

Minimum documentation searched (classification system followed by classification symbols)

IPC:H01L

Documentation searched other than minimum documentation to the extent that such documents are included in the fields searched

Electronic data base consulted during the international search (name of data base and, where practicable, search terms used)

CNTXT, DWPI, ENTXT, ENTXTC, CNKI: 保护, 保留, 第二平坦化层, 第一平坦化层, 非显示区, 焊盘, 绝缘, 钝化, 破坏, 切割, 去除, 去掉, 挖掉, 损伤, protect, reserve, second planarization layer, first planarization layer, non display area, pad, isolation, passivation, invade, cut, remove, excavator, damage

### C. DOCUMENTS CONSIDERED TO BE RELEVANT

| Category* | Citation of document, with indication, where appropriate, of the relevant passages | Relevant to claim No. |
|---|---|---|
| X | CN 106206647 A (LG DISPLAY CO., LTD.) 07 December 2016 (2016-12-07) see description, paragraphs 36-155, and figures 1-5G | 1-2, 6, 19, 26-30 |
| X | KR 20160033571 A (LG DISPLAY CO., LTD.) 28 March 2016 (2016-03-28) see description, paragraphs 24-129, and figures 2-8d | 1-2, 6, 19, 26-30 |
| X | KR 20230034827 A (LG DISPLAY CO., LTD.) 10 March 2023 (2023-03-10) description, paragraphs 18-260, and figures 3-7 | 1-2, 6, 19, 26-30 |
| A | CN 113782692 A (LG DISPLAY CO., LTD.) 10 December 2021 (2021-12-10) entire document | 1-30 |
| A | CN 111880344 A (XIAMEN TIANMA MICRO-ELECTRONICS CO., LTD.) 03 November 2020 (2020-11-03) entire document | 1-30 |
| A | US 2020135819 A1 (SAMSUNG DISPLAY CO., LTD.) 30 April 2020 (2020-04-30) entire document | 1-30 |

☐ Further documents are listed in the continuation of Box C. ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **08 January 2024** | **09 January 2024** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2023/091552**

| Patent document cited in search report | | | Publication date (day/month/year) | Patent family member(s) | | | Publication date (day/month/year) |
|---|---|---|---|---|---|---|---|
| CN | 106206647 | A | 07 December 2016 | US | 2017162834 | A1 | 08 June 2017 |
| | | | | US | 9923175 | B2 | 20 March 2018 |
| | | | | KR | 20160141178 | A | 08 December 2016 |
| | | | | KR | 102540372 | B1 | 05 June 2023 |
| | | | | EP | 3098872 | A1 | 30 November 2016 |
| | | | | EP | 3098872 | B1 | 30 November 2022 |
| | | | | KR | 20230080389 | A | 07 June 2023 |
| | | | | US | 2019252634 | A1 | 15 August 2019 |
| | | | | US | 11189814 | B2 | 30 November 2021 |
| | | | | US | 2016351846 | A1 | 01 December 2016 |
| | | | | US | 9620733 | B2 | 11 April 2017 |
| | | | | US | 2018166657 | A1 | 14 June 2018 |
| | | | | US | 10276838 | B2 | 30 April 2019 |
| | | | | CN | 113540185 | A | 22 October 2021 |
| KR | 20160033571 | A | 28 March 2016 | | None | | |
| KR | 20230034827 | A | 10 March 2023 | CN | 115768190 | A | 07 March 2023 |
| | | | | DE | 102022122284 | A1 | 09 March 2023 |
| | | | | US | 2023075253 | A1 | 09 March 2023 |
| CN | 113782692 | A | 10 December 2021 | US | 2018097047 | A1 | 05 April 2018 |
| | | | | US | 10177206 | B2 | 08 January 2019 |
| | | | | KR | 20180036434 | A | 09 April 2018 |
| | | | | CN | 107887406 | A | 06 April 2018 |
| | | | | CN | 107887406 | B | 07 September 2021 |
| CN | 111880344 | A | 03 November 2020 | CN | 111880344 | B | 10 June 2022 |
| US | 2020135819 | A1 | 30 April 2020 | US | 10825876 | B2 | 03 November 2020 |
| | | | | KR | 102070148 | B1 | 29 January 2020 |
| | | | | CN | 111092054 | A | 01 May 2020 |
| | | | | KR | 20200049713 | A | 08 May 2020 |

Form PCT/ISA/210 (patent family annex) (July 2022)